# EUROPEAN PATENT SPECIFICATION

(11) **EP 1 482 314 B1**
(45) Date of publication and mention of the grant of the patent: **11.11.2009**
(21) Application number: 04018676.9
(22) Date of filing: 15.05.1997
(51) Int. Cl.: G01R 1/067

(54) **Microelectronic spring contact element**
Mikroelektronisches Federkontaktelement
Elément de contact à ressort micro-électronique

(30) Priority: 17.05.1996 US 5189 P; 24.05.1996 WO PCT/US96/08107; 27.06.1996 US 20869 P; 22.08.1996 US 24405 P; 26.08.1996 US 24555 P; 13.11.1996 US 30697 P; 13.12.1996 US 32666 P; 31.12.1996 US 34053 P; 15.01.1997 US 784862; 24.01.1997 US 788740; 18.02.1997 US 802054; 17.03.1997 US 819464
(43) Date of publication of application: 01.12.2004
(62) Divisional of application: 97926534.5
(73) Proprietor: FormFactor, Inc., Livermore, CA 94551 (US)
(72) Inventor: Kahndros, Igor Y., Orinda California 94563 (US); Eldridge, Benjamin N., Danville California 94526 (US); Mathieu, Gaetan L., Varennes, QC J3X 1P7 (CA); Grube, Gary W., Pleasanton 94588 California (US)
(74) Representative: Harris, Ian Richard

(56) References cited:
- EP-A- 0 315 358
- WO-A-96/37332
- DE-C- 4 231 704

## Description

### TECHNICAL FIELD OF THE INVENTION

The present invention relates to resilient electrical contact (interconnection) elements (structures), also referred to as spring contacts, suitable for effecting pressure connections between electronic components and, more particularly, to microminiature spring contacts such as may be used in probing (resiliently and temporarily contacting) microelectronic components such as active semiconductor devices.

### BACKGROUND OF THE INVENTION

Commonly-owned U.S. Patent Application No. 08/152,812 filed 16 Nov 93 (now USP 5,576,211, issued 19 Dec 95), and its counterpart commonly-owned copending "divisional" U.S. Patent Applications Nos. 08/457,479 filed 01 Jun 95 (status: pending) and 08/570,230 filed 11 Dec 95 (status: pending), all by KHANDROS, disclose methods for making resilient interconnection elements for microelectronics applications involving mounting an end of a flexible elongate core element (e.g., wire "stem" or "skeleton") to a terminal on an electronic component coating the flexible core element and adjacent surface of the terminal with a "shell" of one or more materials having a predetermined combination of thickness, yield strength and elastic modulus to ensure predetermined force-to-deflection characteristics of the resulting spring contacts. Exemplary materials for the core element include gold. Exemplary materials for the coating include nickel and its alloys. The resulting spring contact element is suitably used to effect pressure, or demountable, connections between two or more electronic components, including semiconductor devices.

Commonly-owned, copending U.S. Patent Application No. 08/340,144 filed 15 Nov 94 and its corresponding PCT Patent Application No. PCT/US94/13373 filed 16 Nov 94 (WO95/14314, published 26 May 95), both by KHANDROS and MATHIEU, disclose a number of applications for the aforementioned spring contact element, and also disclosed techniques for fabricating contact pads at the ends of the spring contact elements. For example, in Figure 14 thereof, a plurality of negative projections or holes, which may be in the form of inverted pyramids ending in apexes, are formed in the surface of a sacrificial layer (substrate). These holes are then filled with a contact structure comprising layers of material such as gold or rhodium and nickel. A flexible elongate element is mounted to the resulting contact structure and can be overcoated in the manner described hereinabove. In a final step, the sacrificial substrate is removed. The resulting spring contact has a contact pad having controlled geometry (e.g., sharp points) at its free end.

Commonly-owned, copending U.S. Patent Application No. 08/452,255 filed 26 May 95 and its corresponding PCT Patent Application No. PCT/US95/14909 filed 13 Nov 95 (WO96/17278, published 06 Jun 96), both by ELDRIDGE, GRUBE, KHANDROS and MATHIEU, disclose additional techniques and metallurgies for fabricating contact tip structures on sacrificial substrates, as well as techniques for transferring a plurality of spring contact elements mounted thereto, en masse, to terminals of an electronic component (see, e.g., Figures 11A-11F and 12A-12C therein).

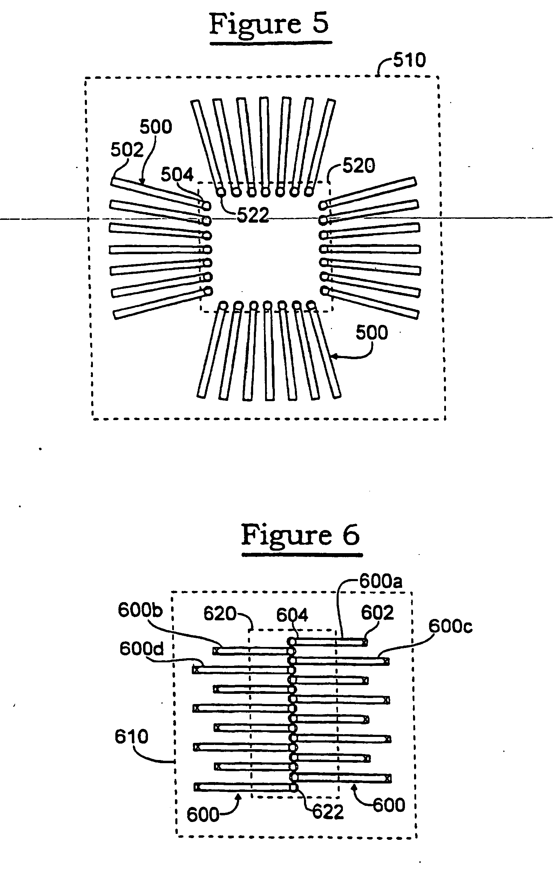

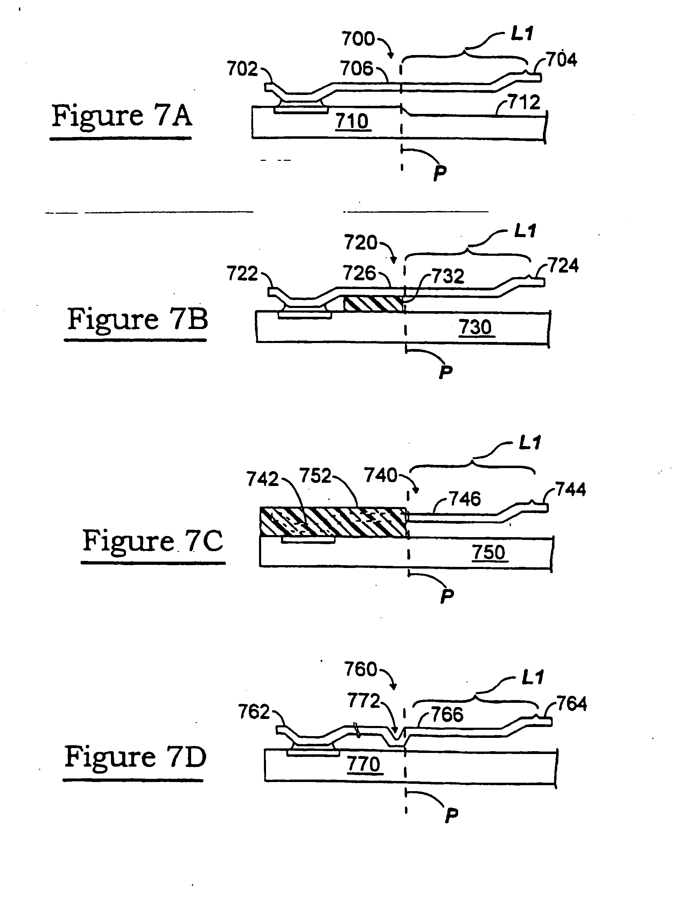

Commonly-owned, copending U.S. Provisional Patent Application No. 60/005,189 filed 17 May 96 and its corresponding PCT Patent Application No. PCT/US96/08107 filed 24 May 96 (WO96/37332, published 28 Nov 96), both by ELDRIDGE, KHANDROS, and MATHIEU, discloses techniques whereby a plurality of contact tip structures (see, e.g, #620 in Figure 6B therein) are joined to a corresponding plurality of elongate contact elements (see, e.g., #632 of Figure 6D therein) which are already mounted to an electronic component (#630). This patent application also discloses, for example in Figures 7A-7E therein, techniques for fabricating "elongate" contact tip structures in the form of cantilevers. The cantilever tip structures can be tapered, between one end thereof and an opposite end thereof. The cantilever tip structures of this patent application are suitable for mounting to already-existing (i.e., previously fabricated) raised interconnection elements (see, e.g., #730 in Figure 7F) extending (e.g., free-standing) from corresponding terminals of an electronic component (see. e.g., #734 in Figure 7F).

This document discloses an electronic component according to the preamble of claim 37.

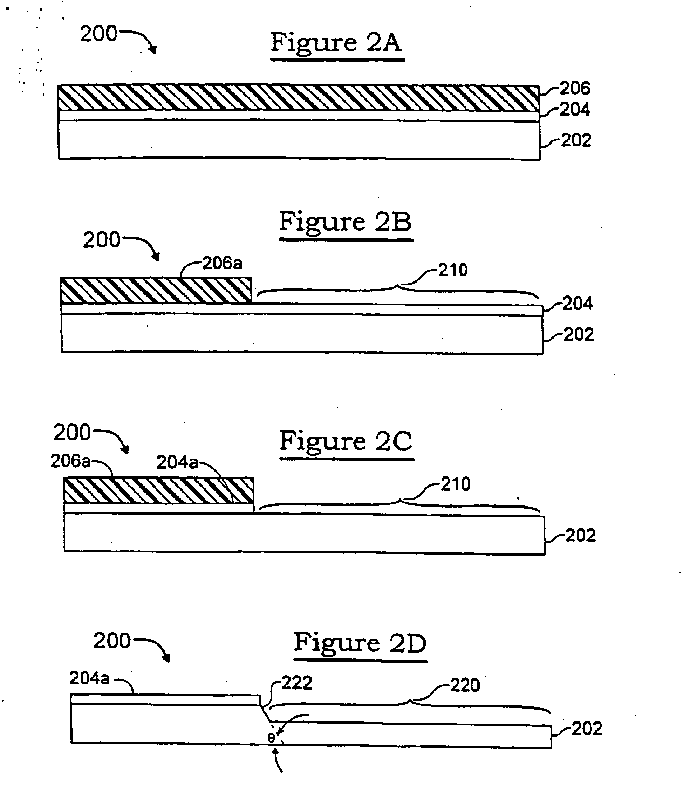

Commonly-owned, copending U.S. Provisional Patent Application No. 60/024,555 filed 26 Aug 96, by ELDRIDGE, KHANDROS and MATHIEU, discloses, for example at Figures 2A-2C thereof, a technique whereby a plurality of elongate tip structures having different lengths than one another can be arranged so that their outer ends are disposed at a greater pitch than their inner ends. Their inner, "contact" ends may be collinear with one another, for effecting connections to electronic components having terminals disposed along a line, such as a centerline of the component.

The present invention addresses and is particularly well-suited to making interconnections to modern microelectronic devices having their terminals (bond pads) disposed at a fine-pitch. As used herein, the term "**fine-pitch**" refers to microelectronic devices that have their terminals disposed at a spacing of less than 5 mils in the following description the unit mils is used. In µm-units 1 mil ≈ 25.4 µm, such as 2.5 mils or 65 µm. As will be evident from the description that follows, this is preferably achieved by taking advantage of the close tolerances that readily can be realized by using lithographic rather than mechanical techniques to fabricate the contact elements.

The above mentioned WO 96/37332 A1 further proposes a spring-shaped interconnection element connected to an electronic component. A column portion of the interconnection element protrudes vertically and is soldered or brazed to the electronic component. A contact end portion of the interconnection element has a tip protruding in an opposite direction.

DE 42 31 704 C1 discloses a method for forming a test needle and also a usage of the needle for measuring dynamic signals on integrated semiconductor components. First, an insulating layer is applied to the needle which can be provided by spraying lacquer, preferably an acrylic lacquer onto the needle or dipping the needle into the lacquer. Then, a conductive layer is provided. The tip of the needle has to be free of lacquer on a length of 100 to 150 micrometers. This is provided in advance by sticking the tip of the needle into a cube to protect the tip, wherein the cube is preferably made of neoprene with an edge length of about 300 micrometers. Or by first coating the whole needle with the insulating layer and the conductive layer, and afterwards removing the redundant part of the coating. Thereafter, the needle is mounted to a probe card and the conductive layer is connected to a ground terminal of the probe card by solder or high-conductive lacquer.

### SUMMARY OF THE INVENTION

An object of the present invention is to provide an improved technique for fabricating and connecting spring contact elements.

It is further an object of the invention to provide an electronic component having a plurality of microelectronic spring contact elements, each comprising an electrically conductive resilient cantilever beam.

The invention is defined in claims 1 and 37, respectively.

Particular embodiments are set out in the dependent claims.

In an embodiment of the invention, an elongate spring contact element suitable for microelectronic applications may be fabricated by forming depressions (such as trenches, such as by etching) in a sacrificial substrate and depositing (such as by plating) metallic materials into the depressions. A plurality of spring contact elements may be fabricated in this manner on a single sacrificial substrate, with lithographically-defined tolerances (e.g., dimensions, spacings).

The resulting spring contact elements may then be mounted to another substrate such as a passive substrate or an active substrate such as a semiconductor device, after which the sacrificial substrate is removed.

In a preferred embodiment a spring contact element is formed in this manner having a length "**L**" between its base end and its contact end. The base end is offset in a first direction from a central portion of the spring contact element, and the contact end is preferably offset in an opposite direction from the central portion. In this manner, the overall spring contact element is not planar and, when its base end is mounted to an electronic component, its contact end extends above the surface of the electronic component to which it is mounted.

An exemplary sacrificial substrate may be used in an embodiment of the invention upon which the spring contact elements may be fabricated is a silicon wafer, in which case the process of the present invention advantageously utilizes the directionally selective etching of silicon used for micro-machining processes to create an electroform which is used to plate up the final spring contact element. This approach may optionally employ laser-based ablation of photoresist, as opposed to lithographic development of the photoresist, in order to create the high aspect ratio of width to height which is required for fine pitch spacings between the spring contact elements.

An exemplary application for the spring contact elements of the present invention is as probe elements used to effect pressure connections between a substrate and a device-under-test (DUT), in which case the spring contact elements are suitably mounted to a space transformer component of a probe card assembly . Alternatively, the spring contact elements are mounted to and extend from an active electronic component such as an application specific integrated circuit (ASIC).

In an embodiment, the spring contact element is suitably formed of at least one layer of a metallic material selected for its ability to cause the resulting contact structure to function, in use, as a spring (i.e., exhibit elastic deformation) when force is applied to its contact (free) end.

In an embodiment the resulting spring contact element is preferably "long and low", having:
- a length "**L**", as measured from one end to another end;
- a height "**H**" measured transverse the length in a direction that is normal (z-axis) to the surface of the sacrificial substrate (and, normal to the component to which the spring contact element is ultimately mounted);
- a contact end portion which is offset in a one direction (e.g., negative along the z-axis) from a central portion of the spring element by a distance "**d1**"; and
- a base end portion which is offset in one direction (e.g., positive z-axis) from the central portion of the spring element by a distance "**d2**".

The spring contact element is preferably tapered from the one (base) end to the other (contact) end thereof, the spring contact element having the following dimensions:
- a width "**w1**" at its base end as measured parallel to the surface of the sacrificial substrate and transverse to the longitudinal axis of the spring element;
- a width "**w2**" at its contact end as measured parallel to the surface of the sacrificial substrate and transverse to the longitudinal axis of the spring element;
- a thickness "**t1**" at its base end, measured along the z-axis; and
- a thickness "**t2**" at its contact end, measured along the z-axis;
resulting in:
- a widthwise taper angle "α" (alpha); and
- a thickness taper angle "β" (beta).

The spring contact element is also suitably provided with a projecting feature at its contact end, said feature having a dimension "**d3**" measured along the z-axis.

There is thus described herein an exemplary spring contact element suitable for effecting connections between two electronic components, typically being mounted by its base end to a one of the two electronic components and effecting a pressure connection with its contact end (e.g., by the projecting feature) to an other of the two electronic components, having the following dimensions (in mils, unless otherwise specified with 1 mil ≈ 25.4 µm)

| dimension | range | preferred |
|---|---|---|
| L | 10-1000 | 60-100 |
| H | 4-40 | 5-12 |
| d1 | 3-15 | 7±1 |
| d2 | 0-15 | 7±1 |
| d3 | 0.25-5 | 3 |
| w1 | 3-20 | 8-12 |
| w2 | 1-10 | 2-8 |
| t1 | 1-10 | 2-5 |
| t2 | 1-10 | 1-5 |
| α | 0-30° | 2-6° |
| β | 0-30° | 0-6° |

Other objects, features and advantages of the invention will become apparent in light of the following description thereof.

### Brief Description of the Drawings

Reference will be made in detail to preferred embodiments of the invention, examples of which are illustrated in the accompanying drawings. The drawings are intended to be illustrative, not limiting.

Certain elements in selected ones of the drawings are illustrated not-to-scale, for illustrative clarity.

Often, similar elements throughout the drawings are referred to by similar references numerals. For example, the element 199 may be similar in many respects to the element 299 in another figure. Also, often, similar elements are referred to with similar numbers in a single drawing. For example, a plurality of elements 199 may be referred to as 199a, 199b, 199c, etc.

**Figure 1A** is a cross-sectional view of a spring contact element, which may be used in an embodiment of the invention.

**Figure 1B** is a plan view of the spring contact element of **figure 1A**, which may be used in an embodiment of the invention.

**Figure 1C** is a cross-sectional view of an alternate embodiment of a spring contact element, which may be used in an embodiment of the invention.

**Figure 1D** is an enlarged cross-sectional view of the spring contact element of **Figure 1C****.**

**Figure 1E** is a cross-sectional view of an alternate embodiment of a spring contact element, which may be used in an embodiment of the invention.

**Figures 2A - 2I** are cross-sectional views of a technique for fabricating spring contact elements on a sacrificial substrate, which may be used in an embodiment of the invention.

**Figure 2J** is a cross-sectional view of a spring contact element residing on a sacrificial substrate, which may be used in an embodiment of the invention.

**Figure 3A** is a cross-sectional view of an alternate embodiment of a spring contact element residing on a sacrificial substrate, which may be used in an embodiment of the invention.

**Figure 3B** is a perspective view of the spring contact element of **Figure 3A**, omitting a showing of the sacrificial substrate, which may be used in an embodiment of the invention.

**Figures 4A-4B** are cross-sectional views illustrating a technique for mounting a plurality of spring contact elements which initially are resident on a sacrificial substrate to another component such as a space transformer, which may be used in an embodiment of the invention.

**Figure 4C** is a cross-sectional view of a plurality of spring contact elements mounted to a component such as a space transformer, in use, probing (making temporary pressure connections with) another component such as a semiconductor device, which may be used in an embodiment of the invention.

**Figure 4D** is a cross-sectional view of another embodiment (compare **Figure 4B**) of a technique for mounting a plurality of spring contact elements to another component such as a space transformer, which may be used in an embodiment of the invention.

**Figure 4E** is a cross-sectional view of another embodiment (compare **Figure 4B**) of a technique for mounting a plurality of spring contact elements to another component such as a space transformer, according to the invention. This figure also illustrates another embodiment of a spring contact element, which may be used in an embodiment of the invention.

**Figure 4F** is a cross-sectional view of another embodiment (compare **Figure 4E**) of a technique for mounting a plurality of spring contact elements to another component such as a space transformer, according to the invention. This figure also illustrates another embodiment of a spring contact element, which may be used in an embodiment of the invention.

**Figure 5** is a schematic (stylized) plan view illustration of an application (use) for the spring contact elements of the present invention.

**Figure 6** is a schematic (stylized) plan view illustration of another application (use) for the spring contact elements of the present invention.

**Figure 7A** is a cross-sectional view of another embodiment (compare **Figure 4D**) of a technique for mounting a spring contact element to another component such as a space transformer, which may be used in an embodiment of the invention.

**Figure 7B** is a cross-sectional view of another embodiment (compare **Figure 7A**) of a technique for mounting a spring contact element to another component such as a space transformer, which may be used in an embodiment of the invention.

**Figure 7C** is a cross-sectional view of another embodiment (compare **Figure 7A**) of a technique for mounting a spring contact element to another component such as a space transformer, which may be used in an embodiment ofthe invention.

**Figure 7D** is a cross-sectional view of another embodiment (compare **Figure 7A**) of a technique for mounting a spring contact element to another component such as a space transformer, which may be used in an embodiment of the invention.

**Figure 8A** is a perspective view of an alternate embodiment of a spring contact element (compare **Figure 3B**), omitting a showing of the sacrificial substrate, which may be used in an embodiment of the invention.

**Figure 8B** is a perspective view of an alternate embodiment of a spring contact element (compare **Figure 8A**), omitting a showing of the sacrificial substrate, which may be used in an embodiment of the invention.

**Figure 9A** is a side cross-sectional view of a first step in a technique for achieving controlled impedance in a spring contact element, according to the invention.

**Figure 9B** is a side cross-sectional view of a next step in the technique for achieving controlled impedance in a spring contact element, according to the invention.

**Figure 9C** is an end cross-sectional view of the controlled impedance spring contact element of **figure 9B**, according to the invention.

### DETAILED DESCRIPTION OF THE INVENTION

Commonly-owned, copending U.S. Patent Application No. 08/554,902 filed 09 Nov 95 and its corresponding PCT Patent Application No. PCT/US95/14844 filed 13 Nov 95 (WO96/15458, published 23 May 96), both by ELDRIDGE, GRUBE, KHANDROS and MATHIEU, disclose a probe card assembly which includes elongate resilient (spring) contact elements mounted to a "**space transformer**" component. As used herein, a **space transformer** is a multilayer interconnection substrate having terminals disposed at a first pitch on a one surface thereof and having corresponding terminals disposed at a second pitch on an opposite surface thereof, and is used to effect "pitch-spreading" from the first pitch to the second pitch. In use, the free ends (tips) of the elongate spring contact elements make pressure connections with corresponding terminals on an electronic component being probed (e.g., tested).

### ELONGATE, RESILIENT CANTILEVER-LIKE CONTACT ELEMENT

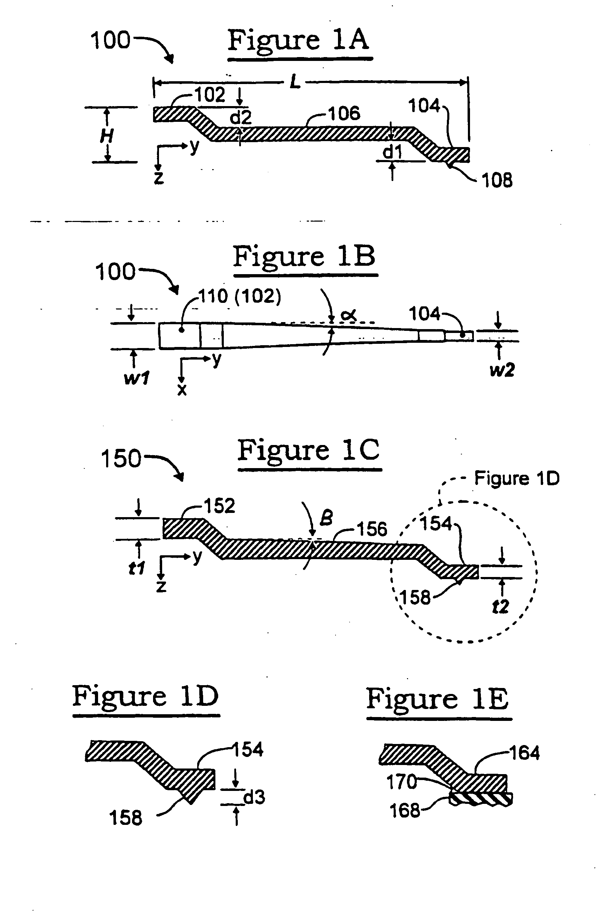

**Figures 1A and 1B** illustrate an elongate resilient (spring) contact element 100 that is suitable for attachment as a free-standing structure to an electronic component including, but not limited to, the space transformer of the aforementioned probe card assembly.

The structure 100 is elongate, has two ends 102 and 104, a central portion 106 therebetween, and has an overall longitudinal length of "**L**" between the two ends. The length "**L**" is in the range of 10-1000 mils, such as 40-500 mils or 40-250 mils, preferably 60-100 mils. As will become apparent from the discussion that follows, in use the structure has an effective length of "**L1**", less than "**L**", which is the length over which the structure can flex in response to a force applied thereto.

The end 102 is a "base" whereat the contact element 100 will be mounted to an electronic component (not shown). The end 104 is a "free-end" (tip) which will effect a pressure connection with another electronic component (e.g., a device-under-test, not shown). Although not illustrated, it is also possible that the contact element 100 has an elongate "tail" portion extending beyond the base end 102, opposite the central portion 106.

The structure 100 has an overall height of "H". The height "H" is in the range of 4-40 mils, preferably 5-12 mils. (1 mil = 0.001 inches)

As best viewed in **Figure 1A**, the structure is "stepped". The base portion 102 is at a first height, the tip 104 is at another height, and a middle (central) portion 106 is at a third height which is between the first and second heights. Therefore, the structure 100 has two "standoff" heights, labelled "**d1**" and "**d2**" in the figure. In other words, the spring contact element 100 has two "steps", a step up from the contact end 104 to the central body portion 106, and a further step up from the central body portion 106 to the base end 102.

In use, the standoff height "**d1**", which is the "vertical" (as viewed in **Figure 1A**) distance between the tip 104 and the central portion 106, performs the function of preventing bumping of the structure (contact element) with a surface of a component being contacted by the tip end 104.

In use, the standoff height "d2", which is the "vertical" (as viewed in **Figure 1A**) distance between the base 102 and the central portion 106, performs the function of allowing the beam (contact element) to bend through the desired overtravel.

The dimensions for the standoff heights "d1" and "d2" are:
- "d1" is in the range of 3-15 mils, preferably approximately 7 mils + 1 mil; and
- "d2" is in the range of 0-15 mils, preferably approximately 7 mils + 1 mil. In the case of "d2" being 0 mil, the structure would be substantially planar (without the illustrated step) between the central portion 106 and the base portion 102.

As best viewed in **Figure 1B**, the structure 100 is preferably provided with a "joining feature" 110 at its base portion 102. The joining feature may be a tab or, optionally a stud, which is used to facilitate brazing the probe structure to a substrate (e.g., a space transformer or a semiconductor device) during assembly therewith. Alternatively, the component or substrate to which the structure 100 is mounted may be provided with a stud or the like to which the base portion 102 is mounted.

In use, the structure 100 is intended to function as a cantilever beam, and is preferably provided with at least one taper angle, labelled "**α**" in **Figure 1B**. For example, the width "**w1**" of the structure 100 at its base end 102 is in the range of 5-20 mils, preferably 8-12 mils, and the width "**w2**" of the structure 100 at its tip end 104 in the range of 1-10 mils, preferably 2-8 mils, and the taper angle "**α**" is preferably in the range of 2-6 degrees. The narrowing of (taper) the structure 100, from its base 102 to its tip 104, permits controlled flexure and more even stress distribution (versus concentration) of the structure 100 when its base 102 is secured (immovable) and a force is applied at its tip (104).

As will be evident in the discussion presented hereinbelow, the width of the structure (hence, the taper angle "α") is readily controlled employing well-known lithographic techniques.

The tip end 104 of the structure 100 is preferably provided with an integral protruding topological feature 108, for example in the geometric form of a pyramid, to aid in effecting pressure connection to a terminal of an electronic component (not shown).

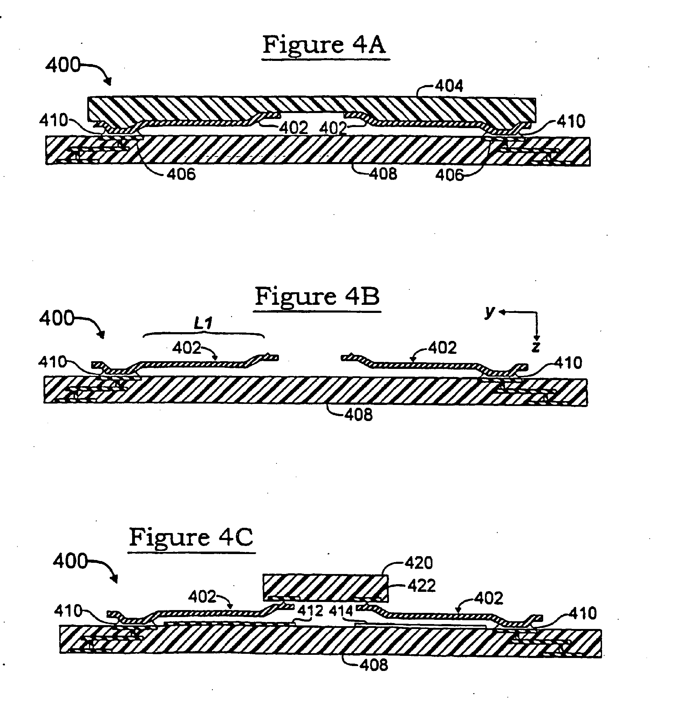

As illustrated in **Figures 1A and 1B**, the spring contact element 100 is three-dimensional, extending in the x- y- and z-axes. Its length "**L**" is along the y-axis, its widths ("**w1**" and "**w2**") is along the x-axis, and its thicknesses ("**t1**" and "**t2**") and height ("**H**") are along the x-axis. As will become evident in the discussion set forth hereinbelow (see, e.g., **Figure 4B**), when the spring contact element 100 is mounted to an electronic component, it is mounted thereto so that the length and width of the spring contact element are parallel to the surface of the electronic component, and its height is normal to the surface of the electronic component.

**Figure 1C** illustrates a contact structure 150 similar in most. respects to the structure 100 of **Figures 1A and 1B**. The structure is elongate, has a base end 152 (compare 102) and a tip end 154 (compare 104), and a topological feature 158 (compare 108) incorporated into its tip end. The principal difference being illustrated in **Figure 1C** is that the structure can be provided with a second taper angle "β".

As best viewed in **Figure 1C**, the thickness "**t1**" of the structure 100 at its base end 102 is in the range of 1-10 mils, preferably 2-5 mils, and the thickness "**t2**" of the structure 100 at its tip end 104 in the range of 1-10 mils, preferably 1-5 mils, and the taper angle "β" is preferably in the range of 2-6 degrees.

The angle "β" (**Figure 1C**) may be created using various methods for controlling the thickness distribution. For example, if the structure 100 is formed by plating, a suitable plating shield can be incorporated into the bath. If the structure 100 is formed other than by plating, appropriate known processes for controlling the spatial distribution of thickness of the resulting structure would be employed. For example, sandblasting or electro-discharge machining (EDM) the structure 100.

Thus, the structure suitably has a composite (dual) taper from its base end 102 to its tip end 104. It has a taper angle "α" which, as will be evident from the description of a contact structure mounted to a component or substrate set forth hereinbelow, is parallel to the x-y plane of the substrate or component to which the contact structure 100 is mounted. And it has a has a taper angle "β" which represents a narrowing of the structure's cross section (z-axis).

It is within the scope of this invention that the structure is not tapered in width, in which case the taper angle "α" would be ZERO. It is also within the scope of this invention that the taper angle "α" is greater than 2-6 degrees, for example as much as 30 degrees. It is within the scope of this invention that the structure is not tapered in thickness, in which case the taper angle "β" would be ZERO. It is also within the scope of this invention that the taper angle "β" is greater than 2-6 degrees, for example as much as 30 degrees. It is within the scope of this invention that the structure (contact element) is tapered only in thickness and not in width, or only in width and not in thickness.

It is within the scope of this invention that the contact element is tapered to be wider and/or thicker at its contact end 104 than at its base end 102, rather than narrower and/or thinner as described above. It is also possible that the contact element is provided with a plurality of different tapers, for example, tapering in (e.g., wider to narrower) from the base end to the central portion, then tapering back out (e.g., narrow to wider) towards the contact end.

The contact structures 100 and 150 are principally, preferably entirely, metallic, and may be formed (fabricated) as multilayer structures, as is described in greater detail hereinbelow. Suitable materials for the one or more layers of the contact structures include but are not limited to:
nickel, and its alloys;
copper, cobalt, iron, and their alloys;
gold (especially hard gold) and silver, both of which exhibit excellent current-carrying capabilities and good contact resistivity characteristics;
elements of the platinum group;
noble metals;
semi-noble metals and their alloys, particularly elements of the palladium group and their alloys; and
tungsten, molybdenum and other refractory metals and their alloys.

In cases where a solder-like finish is desired, tin, lead, bismuth, indium and their alloys can also be used.

**Figure 1D** shows an enlarged view of the contact end 154 of the contact structure 150 (equally applicable to the contact ends of other contact structures illustrated herein). In this enlarged view it can be seen that the contact feature 154 is suitably quite prominent, projecting a distance "**d3**", in the range of 0.25-5 mils, preferably 3 mils from the bottom (as viewed) surface of the contact end of the spring contact element, and is suitably in the geometric shape of a pyramid, a truncated pyramid, a wedge, a hemisphere, or the like.

The resulting spring contact element has an overall height "**H**" which is the sum of "**d1**", "**d2**" (and "**d3**") plus the thickness of the central body portion.

There has thus been described a exemplary spring contact element suitable for effecting connections between two electronic components, typically being mounted by its base end to a one of the two electronic components and effecting a pressure connection with its contact end to an other of the two electronic components, having the following dimensions (in mils, unless otherwise specified):

| dimension | range | preferred |
|---|---|---|
| L | 10-1000 | 60-100 |
| H | 4-40 | 5-12 |
| d1 | 3-15 | 7±1 |
| d2 | 0-15 | 7±1 |
| d3 | 0.25-5 | 3 |
| w1 | 3-20 | 8-12 |
| w2 | 1-10 | 2-8 |
| t1 | 1-10 | 2-5 |
| t2 | 1-10 | 1-5 |
| α | 0-30° | 2-6° |
| β | 0-30° | 0-6° |

from which the following general relationships are evident:
"**L**" is approximately at least 5 times "**H**";
"**d1**" is a small fraction of "**H**", such as between one-fifth and one-half the size of "**H**";
"**w2**" is approximately one-half the size of "**w1**", and is a small fraction of "**H**", such as between one-tenth and one-half the size of "**H**"; and
"**t2**" is approximately one-half the size of "**t1**", such as between one-tenth and one-half the size of "**H**".

Another dimension is of interest - namely, the width and length (i.e., footprint) of the overall tip end (104). In instances where the tip end is expected to make contact with a terminal of an electronic component which is recessed (e.g., a bond pad of a semiconductor device which has passivation material surrounding the bond pad), it may be desirable to ensure that the footprint of the tip end is sufficiently small to make such contact. For example, less than 4 mils by 4 mils). Else, it must be ensured that the contact feature (108) is of sufficient height (**d3**) to make contact with the recessed terminal. Generally speaking, the selection of an appropriate tip end design will be dictated by the peculiarities of the given application. For example, for contacting bond pads on silicon devices, the tip end design illustrated in **Figure 1D** would likely be most appropriate. For contacting C4 bumps, the tip end design illustrated in **Figure 1E** (described hereinbelow) would likely be most appropriate.

**Figure 1E** illustrates an embodiment which may be used in the invention, wherein discrete contact tip structures 168 can be mounted to the contact end portions 164 of the spring contact elements, such as by brazing 170 thereto. This provides the possibility of the contact tip structure 168 having a different metallurgy, than the spring contact element (150). For example, the metallurgy of the spring contact element (150) is suitably targeted at its mechanical (e.g., resilient, spring) characteristics and its general capability to conduct electricity, while the metallurgy of a contact tip structure 168 mounted thereto is appropriately targeted to making superior electrical connection with a terminal (see, e.g., 420, hereinbelow) of an electronic component (see, e.g., 422, hereinbelow) being contacted and, if needed, can have superior wear-resistance.

### FABRICATING THE CONTACT STRUCTURE

A contact element such as that described hereinabove would be difficult, to punch out of a foil of spring material and mount in a precise location on an electronic component such as a space transformer, at the scale (dimensions) described herein.

According to an aspect of the invention, processes such as photolithography are employed to fabricate the spring contact elements of the present invention with tolerances, both of the springs themselves and with regard to the relative locations of a plurality of springs, suitable for use as interconnections in the context of fine-pitch microelectronics.

**Figures 2A-2J** illustrates an exemplary process 200 for fabricating the aforementioned resilient contact structures 100 (150). The present invention is not limited to this exemplary process.

As illustrated in **Figure 2A**, commencing with a suitable sacrificial substrate 202, such as a silicon wafer, a blanket layer 204 of silicon nitride ("nitride") is applied to the surface of the sacrificial substrate. This layer 204 will act as an etch stop in subsequent steps of the process. A layer 206 of a masking material, such as photoresist, is applied over the nitride layer 204, and is imaged and developed using conventional photolithographic techniques (e.g., actinic light passing through a mask).

It is within the scope of this invention that the sacrificial substrate is a material selected from the group consisting of silicon, aluminum, copper, ceramic, and the like. For example, silicon in the form of a silicon semiconductor wafer. Or aluminum or copper in the form of a foil or sheet. Or, aluminum or copper in the form of a layer on another substrate. The sacrificial substrate can also be a "clad" (multilayer) structure, such as copper-invar-copper or aluminum-alumina-aluminum, and preferably has a coefficient of thermal expansion which matches that of the component to which the contact structures are ultimately mounted. The example set forth herein, vis-a-vis the "machining" of the sacrificial substrate is applicable to sacrificial substrates which are silicon. One of ordinary skill in the art to which the present invention most nearly pertains will readily understand how to achieve comparable results with sacrificial substrates formed of other (than silicon) materials. It is within the scope of this invention that the sacrificial substrate can be formed of titanium-tungsten which is readily etched with hydrogen peroxide.

Using conventional chemical etching techniques, an opening 210 to the surface of the sacrificial substrate 202 can be created through both of the layers 206 and 204, as illustrated in **Figure 2C****.** In the area of the opening 210, the surface of the sacrificial substrate is exposed. The surface of the sacrificial substrate is covered by the residual (remaining) portions 204a and 206a of the layers 204, 206, respectively, that are not removed by etching.

Alternatively, as illustrated in **Figure 2B**, selected portions of the photoresist 206 can be removed employing other techniques, such as known techniques involving lasers, E-beam, and the like, and the resulting exposed (no longer covered) portions of the nitride layer 204 can be removed using chemical etching processes, the result of which is that an opening 210 to the surface of the sacrificial substrate 202 can be created, as illustrated in **Figure 2C**. Using a laser to remove portions of the masking layer 206 (other portions 206a being remaining portions) provides the possibility of having more carefully-controlled aspect ratios for the resulting openings 210, for example, obtaining steeper and deeper, more-vertical sidewalls in the opening.

In a next step of the process 200, illustrated in **Figure** **2D**, the sacrificial substrate 202 is etched in the openings 210 through the nitride layer 204, using known chemistry for selectively etching the substrate. For example, a silicon substrate can selectively be etched (with respect to nitride) using potassium hydroxide (KOH). This will create a trench 220 in the substrate 202, the depth of which is controlled to correspond to the aforementioned standoff height "**d2**" (see **Figure 1A**). Also, in the case of employing a silicon wafer as the substrate 202, the sidewall 222 of the trench will favorably exhibit a non-vertical angle "θ", such as 54.74° (rather than 90°), as may be inherent in and controlled by the crystalline structure of the substrate. For example, a silicon substrate having a (100) crystal orientation when etched will etch in the (111) planes.

After creating the trench 220, the residual portion 204a of the etch stop layer 204 is preferably removed.

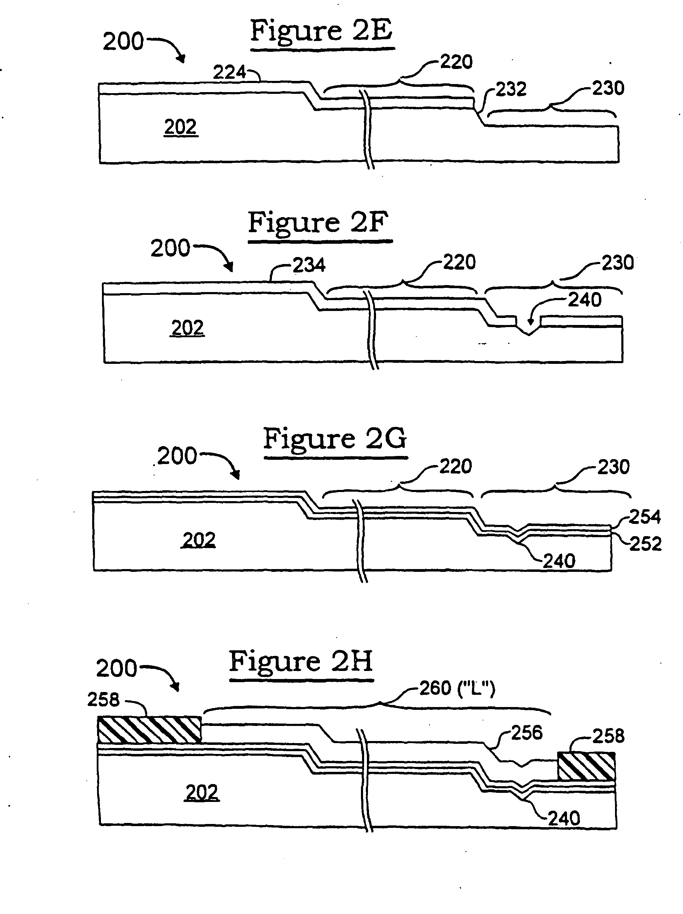

In a next step of the process 200, illustrated in **Figure 2E**, the previous steps illustrated and described with respect to **Figures 2A-2D** are repeated, to create another trench 230 in the sacrificial substrate 202 that is longitudinally offset from and contiguous with the trench 220. Alternatively, the trench 230 can be formed in an end portion (right hand side, as viewed) of the previously-formed trench 220. In other words, an etch stop layer 224 (compare 204) is applied, a masking layer (not shown, compare 206) is applied over the etch stop layer, an opening is created through the masking layer and the etch stop layer, and the substrate is etched. This will result in a trench 230 in the substrate 202, the depth of which is controlled to correspond to the aforementioned standoff height "**d1**" (see **Figure 1A**). Also, as mentioned hereinabove, in the case of employing a silicon wafer as the substrate 202, the sidewall 232 of the trench 230 will favorably be "angled", rather than vertical.

In a next step of the process 200, illustrated in **Figure 2F**, the previous steps illustrated and described with respect to **Figures 2A-2D** are repeated, to create a small geometric intrusion (depression) 240 (compare "**d3**" of **Figure 1D**) in the sacrificial substrate 202 in the bottom of the second trench 230. (The term "**intrusion**" is selected as being the complement to "negative of" the resulting protruding feature (108) that will be fabricated on the resulting spring contact element. The feature 240 could also be considered to be a "**depression**", a "**recess**", an "**indentation**" or an "**intaglio**".) Namely, an etch stop layer 234 (compare 204, 224) is applied, a masking layer (not shown, compare 206) is applied over the etch stop layer, a small opening is created through the masking layer and the etch stop layer, and the substrate is etched. The shape of the intrusion 240 is suitably that of an inverted (as viewed) pyramid and, as mentioned hereinabove, may suitably have sides at the crystalline angle of silicon. As will be evident from the description hereinbelow, this intrusion 240 will define the topological feature 108 present on the tip of the contact structure 100 described hereinabove (pyramid, truncated pyramid, etc.). Finally, the nitride layer 234 is removed.

Each of the trenches 220 and 230 can be considered to be a "subtrench" of a larger overall trench which also includes the depression 240.

The steps described in **Figures 2A-2F** describe the preparation of a sacrificial substrate for the fabrication of resilient contact structures thereon. It is within the scope of this invention that certain of the steps described hereinabove could be performed in other than the recited order. For example, the trench 230 could be formed prior to forming the trench 220.

It bears mention here that it is within the scope of this invention that the process described hereinabove could be carried out on a silicon wafer that has active devices already formed therein. However, as is evident, the forming of trenches (220 and 230) and features (240) could well destroy the active devices unless (i) they were to be formed at areas of the wafer that do not contain active devices, or (ii) the spring contact elements were fabricated on a sacrificial substrate then attached to active devices (see e.g., **Figures 4A-4B** hereinbelow), or (iii) a layer of material suitable for performing the function of the sacrificial substrate (202) described hereinabove is first applied to the surface of the wafer.

As described hereinabove, the sacrificial substrate has been prepared with a first trench 220 which is lower than (extends into) the surface of the substrate, a second trench 230 which is lower than (extends deeper into) and is contiguous (end-to-end) with the first trench 220, and an intrusion (negative projection, depression) 240 within the second trench 230 which extends yet deeper into the substrate. Contact elements will be fabricated in these trenches, then will need to be "released" from the trenches.

In a next step of the process 200, illustrated in **Figure 2G**, one or more metallic layers are blanket deposited, such as by sputtering, onto the substrate 202. For example, a layer 252 of aluminum followed by a layer 254 of copper. Exemplary thicknesses for these layers are:
- 5000-50,000 **Å**, preferably 20,000 **Å** for the first layer 252; and
- 1000-50,000 **Å**, preferably 5,000 **Å** for the second layer 254.

The purposes of these layers 252 and 254 are generally:
- the first layer 252 is a material (such as aluminum) selected for its eventual use as a "release" layer (described hereinbelow); and
- the second layer 254 serves as a "seed" layer for deposition of a subsequent layer (256, described hereinbelow) and, in the case of a previous aluminum layer 252, will prevent the subsequent layer 256 from "smutting" as a result of removing the previous "release" layer 252. This layer may be removed from the final spring contact element and may act as a protective "capping" layer during the release process.

Together, the layers 252 and 254 constitute a "release mechanism" which is incorporated into the sacrificial substrate which, in use, permits the sacrificial substrate to be removed after the spring contact elements fabricated thereon (as described hereinbelow) are mounted to the terminals of the electronic component.

Metallic materials forming the resulting contact structures (100, 150) can be deposited into the trenches and features formed therein by any suitable technique including, but not limited to: various processes involving deposition of materials out of aqueous solutions; electrolytic plating; electroless plating; chemical vapor deposition (CVD); physical vapor deposition (PVD); processes causing the deposition of materials through induced disintegration of liquid or solid precursors; and the like, all of these techniques for depositing materials being generally well known. Electroplating is a generally preferred technique.

Next, as illustrated in **Figure 2H**, a masking layer 258 (compare 206), such as photoresist, is applied to the substrate and is patterned to have an openings 260 corresponding to the length "**L**" and width ("**w1**" and "**w2**", and widths therebetween) of the desired resulting spring contact element (see **Figures 1A and 1B**). A relatively thick "structural" metallic layer 256 is deposited within the openings 260, using any suitable process such as electroplating of a suitable material such as nickel, atop the previously applied layers 252 and 254. This layer 256 is intended to control (dominate) the mechanical characteristics of the resulting spring contact element (100). The opening 260 includes the trench 220, the trench 230, the depression 240 and a portion of the substrate 202 which is adjacent and contiguous with the first trench 220.

An exemplary average ((**t1** + **t2**) / 2) thickness for this layer 256 is 1-10 mils, preferably 1-5 mils. Suitable materials for the layer 256, such as nickel and its alloys, have been set forth hereinabove.

It is within the scope of this invention that additional layers may be included in the build-up of the contact structure. For example, prior to depositing the layer 256, a layer of a material selected for its superior electrical characteristics of electrical conductivity, low contact resistance, solderability, and resistance to corrosion may be deposited. For example, gold or rhodium (both of which are excellent contact materials), nickel-cobalt (a good material for brazing), gold (another good material for brazing), and the like.

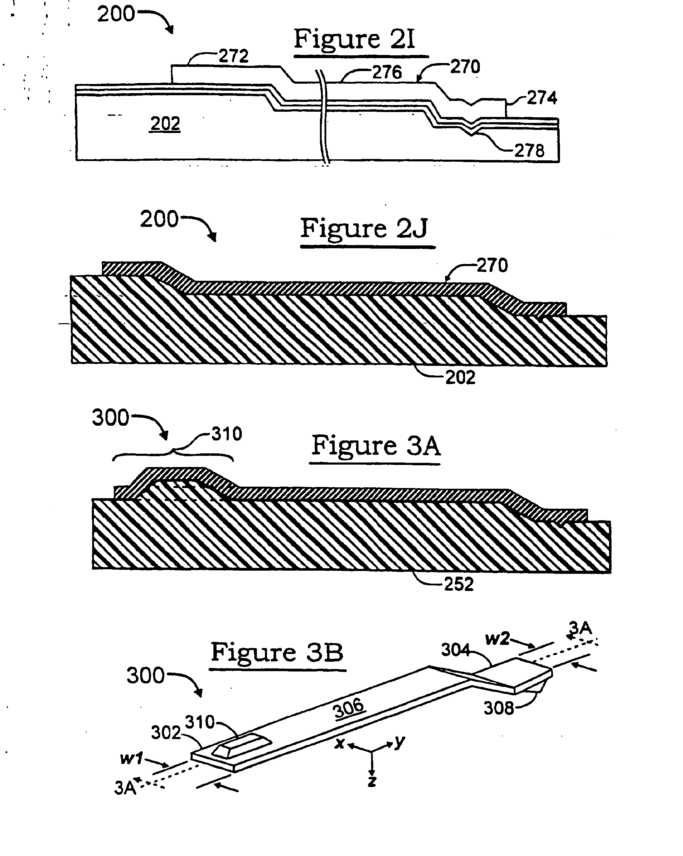

In a next step of the process 200, illustrated in **Figure 2I**, the masking layer 258 is removed, exposing the layers 252 and 254. These layers are suitably selectively chemically etched, so that all that remains on the substrate is an elongate structure 270 (compare 100) having a one end 272 (compare 102), an other end 274 (compare 104), a central portion 276 (compare 106) and a raised topological feature 278 (compare 108) at its end 274. This elongate structure 270 is the resulting spring contact element.

**Figure 2J** is another cross-sectional view of the resulting structure 270, still resident upon the substrate, with the layers 252 and 254 omitted, for illustrative clarity. The similarity between this structure 270 and the spring contact element 100 of **Figure 1A** is readily apparent.

One having ordinary skill in the art to which the present invention most nearly pertains will recognize that the processes described hereinabove can readily be performed at a plurality of locations on a sacrificial substrate to result in a plurality of contact structures (270) having been fabricated at a plurality of precisely-controlled predetermined locations on the substrate 202.
The process has been described with respect to one exemplary structure 270 being fabricated at one location, for purposes of illustrative clarity.

It is within the scope of this invention that rather than patterning a sacrificial substrate to have a plurality of trenches, each corresponding to a single resulting contact element, that a sacrificial substrate can be prepared with a single very wide set of trenches,(220, 230, 240), then deposit the metals (252, 254, 256), then perform an additional final masking and etching step to define the individual contact elements. Such a process would look similar to the process described hereinabove with respect to **Figures 2A-2G**, followed by blanket deposition of the metal (256) layers, followed by masking and etching to define the individual contact elements.

### AN ALTERNATE EMBODIMENT which may be used in the invention

**Figures 3A and 3B** illustrate another one of many possible embodiments for a contact structure 300 fabricated by the techniques described hereinabove. Instead of a flat connection tab (see 110), a somewhat truncated-pyramidal joining feature (stud) 310 is fabricated as an attachment feature at the base portion 304 of the contact structure 300. When the contact structure 300 is mounted to a substrate, such as a space transformer, this stud 310 will allow for some misalignment tolerance during assembly. The remaining portions of the contact structure 300 are comparable to those described hereinabove with respect to the contact structure 270 -namely, a central main body portion 306 (compare 276), a contact end portion 304 (compare 274), and a feature 308 (compare 278).

Thus, there has thus been shown an exemplary process for fabricating elongate resilient (spring) interconnection (contact) elements on a sacrificial substrate. This can be considered to be an "interim" product, awaiting further use, as follows:
Alternative A: These spring contact elements can simply be removed from the sacrificial substrate, resulting in a "bucket of springs" which may be attached, such as with automated equipment, to an electronic component, although the benefit of having lithographically (i.e., to very close tolerances) located the plurality of spring contact elements with respect to one another would be lost.
Alternative B: A more "viable" technique for installing the spring contact elements onto an electronic component, involving removing the sacrificial substrate after the contact structures resident thereon are mounted (by the base ends) to an electronic component or to a substrate, is described hereinbelow with respect to **Figures 4A-4C**.

### REMOVING THE SACRIFICIAL SUBSTRATE

With regard to either of the alternatives ("A" or "B", set forth hereinabove, a suitable mechanism must be employed for removing the sacrificial substrate (i.e, releasing the fabricating contact elements from the sacrificial substrate whereupon they reside). Exemplary suitable mechanisms include, but are not limited to:
- chemically etching to release the contact structures (e.g., 270) from the sacrificial substrate (202). As mentioned above, the aluminum layer 252 is readily selectively etched to cause separation of the contact structure 270 from the substrate 202. (The copper layer 254 helps prevent contamination of the layer 256 in such a process, and may ultimately be etched from the separated contact structure 270.)
- in lieu of the aluminum and copper layers described hereinabove, employing layers of materials that are non-wetting with respect to one another and/or that ball up when heated (e.g., lead, indium, tin), then heating the substrate 202 to cause the contact structures 270 to be released therefrom.

### MOUNTING THE CONTACTS TO A SUBSTRATE

As mentioned hereinabove, a plurality of contact structures (e.g., 270) fabricated upon a sacrificial substrate (e.g., 202) can be mounted (affixed) to another substrate or to an electronic component such as a space transformer.

**Figure 4A** illustrates a technique 400 wherein a plurality (two of many shown) of contact structures 402 (compare 100, 150, 270, 300) have been fabricated on a sacrificial substrate 404 (compare 202). The base end portions (compare 310) of the contact structures 402 are brought into contact with a corresponding plurality of terminals 406 on an electronic component 408 such as the aforementioned space transformer of a probe card assembly, whereupon the base end portions are suitably soldered or brazed 410 to the terminals 406.

It is within the scope of this invention that any suitable technique and/or material for affixing the base end portions of the contact structures (402) to terminals of an electronic component be employed, including brazing, welding (e.g., spot welding), soldering, conductive epoxy, tacking the contact structure in any suitable manner to the terminal and securely affixing the contact structure to the terminal by plating (e.g., electroplating), and the like.

The sacrificial substrate 404 is now removed, in any suitable manner such as those described hereinabove (e.g., chemical etching, heating), resulting in an electronic component (408) having spring contact elements (402) affixed thereto, as illustrated in **Figure 4B**.

As is evident in **Figure 4B**, a plurality of elongate spring contact elements can be mounted to an electronic component having a plurality of terminals on a surface thereof. Each spring contact element has a base end and a contact end opposite the base end, and is mounted by its base end to a corresponding terminal of the electronic component. The contact end of each spring contact element extends above the surface of the electronic component to a position which is laterally offset from its base end.

As mentioned hereinabove, when mounted, the contact structure 402 (compare 100) has an "effective" length of "**L1**", this being the length between the tip feature (compare 108) and the inwardmost position whereat the base end (compare 102) is affixed to the component 408. The "effective" length represents the length over which the contact structure can deflect in response to compressive forces applied at the tip end thereof (e.g., at the tip feature).

**Figure 4C** illustrates an application for the spring contact elements (resilient contact structures) of the present invention wherein the spring contact elements have been mounted in the manner described with respect to **Figure 4B** to a space transformer component (408) of a probe card assembly (not shown) so that the contact features (compare 308) at their contact ends (compare 304) make pressure connections with terminals 422 of an electronic component 420 such as a semiconductor device, or an area of a semiconductor wafer (not shown) containing a plurality of semiconductor devices. As described hereinabove, with respect to **Figure 1E**, it is within the scope of this invention that separate and discrete contact tip structures (168) be affixed to the contact end portions of the spring contact element.

It is within the scope of this invention that the substrate (component) to which the structures 402 are mounted, for example the component 408 illustrated in **Figure 4C** are active components, such as ASICs.

It is also within the scope of the invention, as is illustrated in **Figure 4C****,** that the component or substrate to which the structures (e.g., 402) are mounted can be provided with a contiguous (as illustrated) or segmented ground plane to control impedance. Such a ground plane may comprise a plurality of ground lines 412 aligned directly underneath the structures 402, but sufficient clearance for the tip of the structure to deflect must be assured. Alternatively, the ground plane 412 can be covered with an insulating layer. Another approach would be to dispose ground plane lines 414 on the surface of the substrate 408 slightly (such as 1 mil, in the x-axis) offset from directly underneath the structures 402, and laying parallel to the structure.

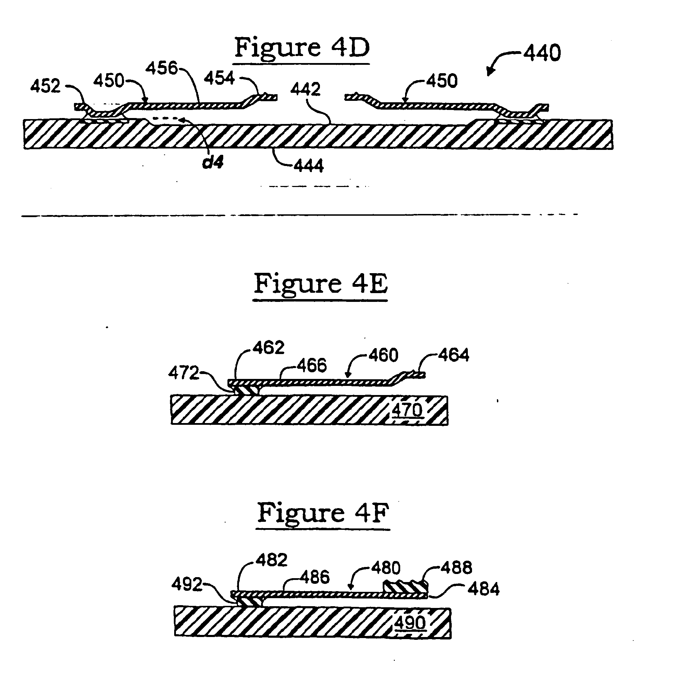

**Figure 4D** illustrates an alternate structure 440 which may be used in an embodiment of the present invention wherein a cavity (trench) 442 is been formed in the surface of the substrate or component 444 (compare 408) to which the contact structures 450 (compare 402) have been mounted. The trench 442 is located so that it is underneath at least the contact end portion 454 (compare 104) of the contact structure, and preferably extends underneath a substantial portion of the contiguous central body portion 456 (compare 106) of the spring contact element. The trench extends of a depth "**d4**" within the substrate 444 a suitable distance to allow for a greater range of deflection of the contact end portion 454 when, in use, it is urged against an electronic component (see, e.g., **Figure 4C**). In **Figure 4D****,** one trench 442 is illustrated extending under a plurality (two of many shown) spring contact elements. It is within the scope of this invention that there is a single discrete trench under each of the plurality of spring contact elements (.450) structures mounted to an electronic component (444).

**Figure 4E** illustrates an alternate structure which may be used in an embodiment of the present invention wherein a spring contact element 460 is mounted to an electronic component 470 (compare 444) via a stud 472 extending from a surface of the electronic component 470. The base end 462 of the spring contact element 460 is suitably brazed to the stud 472. The stud 472 suitably has a height in the range of 3-4 mils.

**Figure 4E** also illustrates an alternate structure which may be used in an embodiment of the present invention wherein the spring contact element 460 is formed with but a single step or offset (rather than two steps). As illustrated herein, the offset of the base end portion 462 from the central body portion 466 (compare "**d2**" in **Figure 1A**) is ZERO. In other words, in this example, the base end portion 462 is coplanar with the central body portion 466. Since there is no offset at the base end portion, the base end 462 is mounted to a stud 472 on the surface of the electronic component 470 so that the body portion 466 is elevated above the surface of the component 470. The contact end portion 464 (compare 104) preferably remains offset by a distance "**d1**" from the central body portion 466. As suggested by this figure, many of the variations (alternate embodiments) of the present invention can be combined (mixed and matched) to arrive at a desired arrangement of spring contact elements affixed to an electronic component.

**Figure 4F** illustrates another structure which may be used in an embodiment of the invention wherein the spring contact element (contact structure) 480 is formed without any step or offset (rather than one or two steps). As in the previous example, the offset of the base end portion 482 from the central body portion 486 (compare "**d2**" in **Figure 1A**) is ZERO, and the base end portion 482 is coplanar with the central body portion 486. Since there is no offset at the base end portion, the base end 482 is mounted to a stud 492 on the surface of the electronic component 490 so that the body portion 486 is elevated above the surface of the component 490. Also, the offset of the contact end portion 484 (compare 104) from the central body portion 486 (compare "**d1**" in **Figure 1A**) is ZERO, and the contact end portion 484 is coplanar with the central body portion 486. Since there is no offset at the contact end portion, a prefabricated contact tip structure 488 (compare 168) may be affixed (e.g., joined, such as by brazing) to the contact end 484 so that the body portion 486 will be spaced away from a component (not shown, compare 420) being contacted by the contact structure 480.

### PROBE APPLICATIONS

**Figure 5** illustrates an application wherein a plurality of spring contact elements 500 such as those described hereinabove are arranged on a substrate such as a space transformer, and affixed thereto in the manner described hereinabove, so that their contact ends are disposed in a manner suitable for making contact with the bond pads of a semiconductor device having its bond pads arranged along its periphery.

Each contact element 500 (compare 100) has a base end 502 (compare 102) and a contact end 504 (compare 104), and are mounted to an electronic component such as a space transformer component (schematically illustrated by the dashed line 510) of a probe card assembly. The contact ends 504 are arranged close to one another, in a pattern mirroring that of the bond pads 522 (illustrated schematically by circles) of an electronic component (schematically illustrated by the dashed line 520) such as a semiconductor device. The spring contact elements 500 "fan-out" from their contact ends 504, so that their base ends 502 are disposed at a greater pitch (spacing from one another) than their contact ends 504.

**Figure 6** illustrates another application wherein a plurality of spring contact elements 600 such as those described hereinabove are arranged on a substrate such as a space transformer, and affixed thereto in the manner described hereinabove, so that their contact ends are disposed in a manner suitable for making contact with the bond pads of a semiconductor device having its bond pads arranged in a row along a centerline thereof.

Each spring contact element (compare 100), generally denoted by the reference numeral 600, has a base end 602 (compare 102) and a contact end 604 (compare 104), and are mounted to an electronic component such as a space transformer component (schematically illustrated by the dashed line 610) of a probe card assembly (not shown). The contact ends 604 are arranged close to one another, in a pattern mirroring that of the bond pads 622 (illustrated schematically by circles) of an electronic component (schematically illustrated by the dashed line 620) such as a semiconductor device. The spring contact elements 600 are arranged in the following sequence:
- a first spring contact element 600a is relatively short (e.g., has a length of 60 mils ), and is disposed to extend towards a one side (right, as viewed) of the electronic component 620;
- a second spring contact element 600b, adjacent the first spring contact element 600a, is also relatively short (e.g., has a length of 60 mils ), and is disposed to extend towards an opposite side (left, as viewed) of the electronic component 620;
- a third spring contact element 600c, adjacent the second spring contact element 600b, is relatively long (e.g., has a length of 80 mils ), and is disposed to extend towards the one side (right, as viewed) of the electronic component 620; and
- a fourth spring contact element 600d, adjacent the third spring contact element 600c, is also relatively long (e.g., has a length of 80 mils ), and is disposed to extend towards the opposite side (left, as viewed) of the electronic component 620. In this manner, the contact ends 604 are disposed at a fine-pitch commensurate with that of the bond pads 622, and the base ends 602 are disposed at a significantly greater pitch from one another.

The showing of only two different-length contact structures is merely exemplary and it should be understood that it is within the scope of this invention that a plurality of spring contact elements having more than two different lengths can be disposed on a common substrate. The showing of only two different-length contact structures is merely exemplary.

It is within the scope of this invention that the techniques illustrated in **Figures 5 and 6** may be used to generate a plurality of probes (spring contact elements) in any arrangement required for probing of either peripheral or lead-on-center (LOG) devices.

### ADDITIONAL FEATURES AND EMBODIMENTS

In cases where there are a plurality of spring contact elements mounted to a substrate and they are of different lengths (see, e.g., **Figure 6**), and assuming that the cross-sections and metallurgy of the spring contact elements are the same as one another, the different length spring contact elements will evidently exhibit different reactive forces (spring constants, k).

It is therefore within the scope of this invention that the spring constants of a plurality of spring elements exhibiting different spring constants can be adjusted (tailored), on an individual basis, to make them more uniform with one another.

**Figure 7A** illustrates a technique for tailoring spring constant. In this example, a spring contact element 700 (compare 450) is mounted by its base end 702 (compare 452) to an electronic component 710 (compare 444). A trench 712 (compare 442) is formed in the surface of the electronic component 710 and extends from under the contact end 704 (compare 454) of the spring contact structure 700, along the body portion 706 (compare 456) thereof, towards the base end 702 of the spring contact element 700 to a position (point) "**P**" which is located a prescribed, fixed distance, such as 60 mils from the contact end 704. When a force is applied downwards to the contact end 704, the entire spring contact element 700 will bend (deflect) until the body portion 706 contacts the end of the trench 712 at the point "**P**", whereupon only the outermost portion (from the point "**P**" to the end 704) of the spring contact element is permitted to deflect. The outermost portion of the spring contact element has an 'effective' length of "**L1**". The outermost portion of the spring contact element has an 'effective' length of "**L1**". In this manner, the reaction to applied contact forces can be made uniform among spring contact elements of various lengths (so long as the point "**P**" falls somewhere within the central body portion of the spring contact element).

**Figure 7B** illustrates another technique for tailoring spring constant. In this example, a spring contact element 720 (compare 450) is mounted by its base end 702 (compare 452) to an electronic component 710 (compare 444). A structure 732 (compare 712) is formed on the surface of the electronic component 730 (compare 710) at a location between the base end 722 of the spring contact structure 720, between the surface of the electronic component 730
and the central body portion 726 (compare 706) of the spring contact element 720 and extends along the body portion 726 (compare 706) thereof, towards the contact end 724 of the spring contact element 720 to a position (point) "**P**" which is located a prescribed, fixed distance, such as the aforementioned (with respect to **Figure 7A**) prescribed distance, from the contact end 724. The structure is suitably a bead of any hard material, such as glass or a pre-cut ceramic ring, disposed on the surface of the electronic component 730. When a force is applied downwards to the contact end 724, only the outermost portion (from the point "**P**" to the end 724) of the spring contact element is permitted to deflect. As in the previous embodiment, the reactions to applied contact forces can be made uniform among spring contact elements of various lengths.

**Figure 7C** illustrates yet another technique for tailoring spring constant. In this example, a spring contact element 740 (compare 720) is mounted by its base end 742 (compare 722) to an electronic component 750 (compare 730). An encapsulating structure 752 (compare 732) is formed on the surface of the electronic component 750 in a manner similar to the structure 732 of the previous embodiment. However, in this case, the structure 752 fully encapsulates the base end 742 of the spring contact structure 740 and extends along the body portion 746 (compare 726) thereof, towards the contact end 744 thereof, to a position (point) "**P**" which is located a prescribed, fixed distance, such as the aforementioned (with respect to **Figure 7A and 7B** prescribed distance, from the contact end 744. The outermost portion of the spring contact element has an 'effective' length of "**L1**". As in the previous embodiment, when a force is applied downwards to the contact end 744, only the outermost portion (from the point "**P**" to the end 744) of the spring contact element is permitted to deflect. As in the previous embodiment, the reactions to applied contact forces can be made uniform among spring contact elements of various lengths.

**Figure 7D** illustrates yet another technique for tailoring spring constant. In this example, a spring contact element 760 (compare 740) is mounted by its base end 762 (compare 742) to an electronic component 770 (compare 750). In this example, the body portion 766 is formed with a "kink" 772 at a position (point) "**P**" which is located a prescribed, fixed distance, such as the aforementioned (with respect to **Figure 7A-7C** prescribed distance, from the contact end 764. The outermost portion of the spring contact element has an 'effective' length of "**L1**". As in the previous embodiment, when a force is applied downwards to the contact end 744, only the outermost portion (from the point "**P**" to the end 744) of the spring contact element is permitted to deflect. (The kink 772 can be sized and shaped so that the entire contact structure deflects slightly before the kink 772 contacts the surface of the component 770, after which only the outermost portion of the spring element will continue to deflect.) As in the previous embodiment, the reactions to applied contact forces can be made uniform among spring contact elements of various lengths.

It is within the scope of this invention that other techniques can be employed to "uniformize" the spring constants among contact elements having different overall lengths ("L"). For example, their widths and or "α" taper can be different from one another to achieve this desired result.

### ALTERNATE EMBODIMENT

The spring contact elements illustrated and described hereinabove have been elongate and linear (disposed along the y-axis) , generally best suited to accommodate movement (deflection) in the z-axis (i.e., normal to the component or substrate to which they are mounted).

It is within the scope of this invention that additional "dimensionality" and commensurate additional freedom of movement be incorporated into the resulting spring contact element.

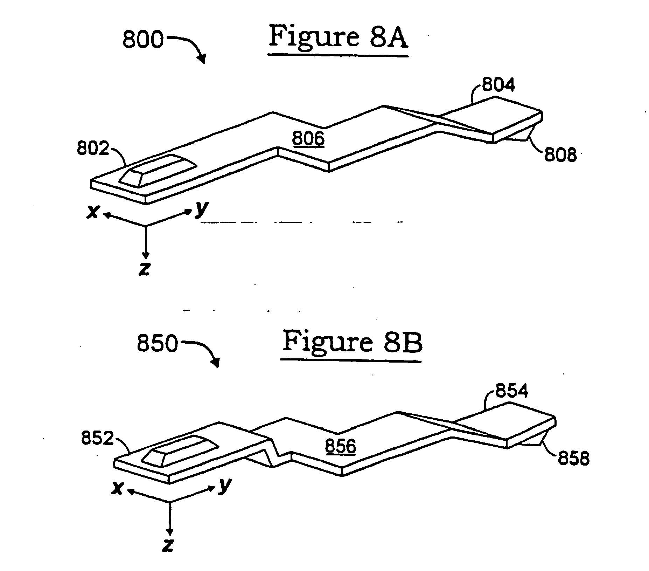

**Figure 8A** illustrates a spring contact element 800 that has been fabricated according to the techniques set forth hereinabove, with the exception (noticeable difference) that the central body portion 806 (compare 106) of the contact element is not straight, Although it may still lay in a plane (e.g., the x-y plane), it is illustrated as jogging along the x-axis while traversing the y-axis, in which case the base end 802 (compare 102) will have a different x-coordinate than the contact end 804 (compare 104) or the contact feature 808 (compare 108) disposed at the contact end 804.

**Figure 8B** illustrates a spring contact element 850 that is similar in many respects to the spring contact element 800 of **Figure 8A**, with the exception that there is a step between the central body portion 856 (compare 806) and the base portion 852 (compare 802) in addition to the step between the central portion 856 and the contact end portion 854 (compare 804). The contact element 850 is illustrated with a contact feature 858 (compare 808) at its contact end 854.

### CONTROLLED IMPEDANCE

For use in probing semiconductor devices, particularly at speed testing, it is advantageous that the spring contact element have controlled impedance.

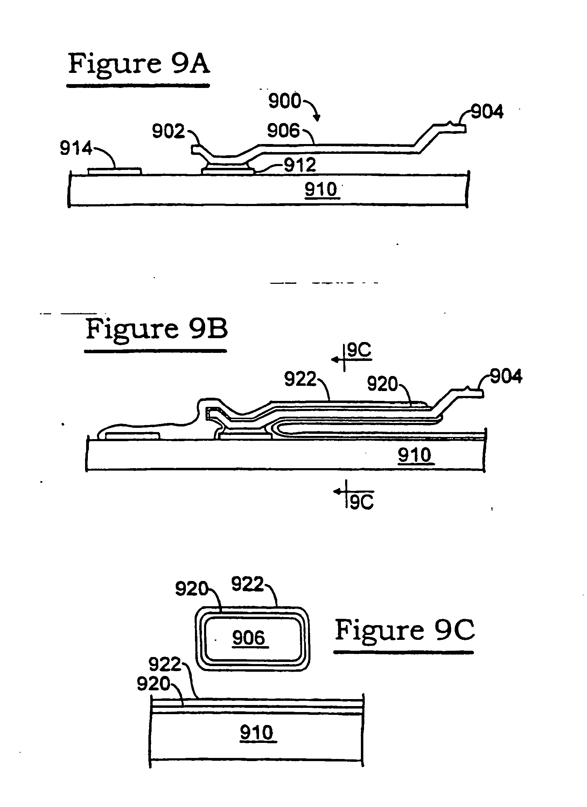

**Figures 9A-9C** illustrate a technique 900 for achieving controlled impedance in a spring contact element, according to the invention.

In a first step, best viewed in **Figure 9A**, a spring contact element 900 (compare 700) is mounted by its base end 902 (compare 702) to a terminal 912 of an electronic component 910 (compare 710) such as a space transformer component of a probe card assembly. The contact tip end 904 (compare 704) is elevated above the surface of the component 910 and is illustrated as having a contact feature. The spring contact structure has a central body portion 906 (compare 706) between its base and tip ends.

In a next step, best viewed in **Figure 9B**, the tip end 904 of the spring contact element is masked (not shown), and a suitable thin (e.g., 1-10 µm) insulating layer 920, such as parylene, is deposited, such as by vapor deposition, onto all but the tip end 904 of the spring contact element, and adjacent surface of the electronic component.

In a next step, best viewed in **Figure 9B**, while the tip end 904 of the spring contact element is still masked (not shown), a suitable thin (e.g., less than 0.25 mm) layer 922 of conductive material, such as any of the conductive metal material described herein, is deposited, such as by sputtering, onto all but the tip end 904 of the spring contact element, and adjacent surface of the electronic component. Finally, the tip end 904 is unmasked. This results in the central body portion 906 of the spring contact element being enveloped by a conductive layer 922, with an insulating layer 920 therebetween.

The conductive layer 922 is suitably connected to ground to function as a ground plane and control the impedance of the resulting spring contact element. For example, as best viewed in **Figure 9A, 9B**, the component 910 is provided with a second terminal 914 which is electrical ground. This terminal 914 is suitably masked along with the tip end 904 of the spring contact element prior to applying the insulating layer 920, so that the subsequent conductive layer 922 will also deposit thereon and be connected thereto.

Evidently, this thicknesses of the layers 920 and 922 need only be sufficient to be continuous, and to provide the sought after controlled impedance, and should not be so thick as to interfere with the mechanical operation of the spring contact element. The representations in **Figures 9B and 9C** are not drawn to scale.

Although the invention has been illustrated and described in detail in the drawings and foregoing description, the same is to be considered as illustrative and not restrictive in character - it being understood that only preferred embodiments have been shown and described, and that all changes and modifications that come within the scope of the invention are desired to be protected. Undoubtedly, many other "variations" on the "themes" set forth hereinabove will occur to one having ordinary skill in the art to which the present invention most nearly pertains, and such variations are intended to be within the scope of the invention, as disclosed herein.

For example, the resulting spring contact elements may be heat-treated to enhance their mechanical characteristics, either while they are resident upon the sacrificial substrate or after they are mounted to another substrate or an electronic component. Also, any heat incident to mounting (e.g., by brazing) the spring contact elements to a component can advantageously be employed to "heat treat" the material of the spring contact element.

For example, a comparable spring contact element could be fabricated without etching into the sacrificial substrate, by disposing multiple layers of photoresist (masking material) onto a substrate, forming openings therein, seeding the opening for electroplating or the like, building up a metallic mass within the opening, and removing the photoresist. Such a technique would be particularly well suited to fabricating spring contact elements directly upon active semiconductor devices.

For example, it is within the scope of this invention that the contact structure can be fabricated on or attached to active semiconductor devices.

## Claims

1. Method of mounting microelectronic spring contact elements on an electronic component (910),
the electronic component (910) comprising:
a plurality of first terminals (912) on a surface thereof; the electronic component (910) further comprising at least one second terminal (914); and each microelectronic spring contact element comprising:
an electrically conductive resilient beam (900) comprising a contact end portion (904) protruding from the beam (900) in a first direction and a base end portion (902) protruding from the beam (900) in a second direction; the contact end portion (904) of the beam (900) being elevated above the surface of the electronic component (910) to a position which is laterally offset from the base end portion (902), and the method comprising the steps of:
for each microelectronic spring contact element affixing the base end portion (902) to one of the first terminals (912) of the electronic component (910),
masking the contact end portions (904),
depositing an insulating layer (920) enveloping at least a portion of the beams (900); and
depositing a conductive layer (922) enveloping at least a portion of the insulating layer (920).

2. Method according to claim 1, wherein:
the beam (900) has a length "L";
the contact end portion (904) protrudes in the first direction from the beam (900) by a distance "d1"; and
the base end portion (902) protrudes in the second direction opposite the first direction from the beam by a distance "d2" ;
wherein the contact end portion (904) is adapted in use to make a pressure connection with a second electronic component.

3. Method according to claim 2, wherein the distance "d1" is in the range of 76 - 381 µm (3-15 mils).

4. Method according to claim 3, wherein the distance "d1" is approximately 178 µm (7 mils).

5. Method according to claim 2, wherein the distance "d2" is in the range of 0 - 381 µm (0-15 mils).

6. Method according to claim 5, wherein the distance "d2" is approximately 178 µm (7 mils).

7. Method according to claim 2, wherein
the distance "d1" is in the range of 76 - 381 µm (3-15 mils); and
the distance "d2" is in the range of 0 - 381 µm (0-15 mils).

8. Method according to claim 1, wherein each of the microelectronic spring contact elements is thicker at the base end portion (902) than at the contact end portion (904).

9. Method according to claim 1, wherein a thickness "t1" of the base end portion (902) is in the range of 25.4 - 254 µm (1-10 mils).

10. Method according to claim 9, wherein the thickness "t1" of the base end portion (902) is in the range of 51 - 127 µm (2-5 mils).

11. Method according to claim 1, wherein a thickness "t2" of the contact end portion (904) is in the range of 25.4 - 254 µm (1-10 mils).

12. Method according to claim 11, wherein the thickness "t2" of the contact end portion (904) is in the range of 25.4 - 127 µm (1-5 mils).

13. Method according to claim 8, wherein each of the microelectronic spring contact elements has a thickness taper angle "β" in the range of 0-30 degrees.

14. Method according to claim 13, wherein each of the microelectronic spring contact elements has a thickness taper angle "β" in the range of 0-6 degrees.

15. Method according to claim 1, wherein each of the microelectronic spring contact elements is wider at the base end portion (902) than at the contact end portion (904).

16. Method according to claim 1, wherein a width "w1" of the base end portion (902) is in the range of 76 - 508 µm (3-20 mils).

17. Method according to claim 16, wherein the width "w1" of the base end portion (902) is in the range of 203 - 305 µm (8-12 mils).

18. Method according to claim 1, wherein a width "w2" of the contact end portion (904) is in the range of 25.4 - 254 µm (1-10 mils).

19. Method according to claim 18, wherein the width "w2" of the contact end portion (904) is in the range of 51 - 203 µm (2-8 mils).

20. Method according to claim 15, wherein each of the microelectronic spring contact elements has a widthwise taper angle "α" in the range of 2-6 degrees.

21. Method according to claim 1, wherein each of the microelectronic spring contact elements is thicker at the base end portion (902) than at the contact end portion (904);
each of the microelectronic spring contact elements is wider at the base end portion (902) than at the contact end portion (904);
each of the microelectronic spring contact elements has a thickness taper angle "β" in the range of 0-6 degrees; and
each of the microelectronic spring contact elements has a widthwise taper angle "α" in the range of 2-6 degrees.

22. Method according to claim 2, wherein the length "L" is in the range of 254 µm - 25.4 mm (10-1000 mils).

23. Method according to claim 22, wherein the length "L" is in the range of 1524 - 2540 µm (60-100 mils).

24. Method according to claim 2, wherein
each of the microelectronic spring contact elements has an overall height "H" which is the sum of "d1", "d2" and a thickness of the beam (900); and
the overall height "H" is in the range of 102 - 1016 µm (4-40 mils).

25. Method according to claim 24, wherein the overall height "H" is in the range of 127 - 305 µm (5-12 mils).

26. Method according to claim 2, wherein
each of the microelectronic spring contact elements has an overall height "H" which is the sum of "d1", "d2" and a thickness of the beam (900); and
the length "L" is approximately at least FIVE times the overall height "H".

27. Method according to claim 2, wherein
each of the microelectronic spring contact elements has an overall height "H" which is the sum of "d1", "d2" and a thickness of the beam (900); and
the distance "d1" is between one-fifth and one-half the size of the overall height "H".

28. Method according to claim 2, wherein:
each of the microelectronic spring contact elements has an overall height "H" which is the sum of "d1", "d2" and a thickness of the beam (900);
the beam has a width "w1" at its base end portion (902);
the beam has a width "w2" at its contact end portion (904); and
the width "w2" is between one-tenth and one-half the size of the overall height "H".

29. Method according to claim 1, wherein the contact end portion (904) is provided with an integral protruding feature (108, 158).

30. Method according to claim 29, wherein the integral protruding feature (108, 158) is in the form of a pyramid or a truncated pyramid.

31. Method according to claim 29, wherein the integral protruding feature (108, 158) protrudes a distance "d3" from a surface of the contact end portion (904) which is in the range of 6.3 - 127 µm (0.25 - 5 mils).

32. Method according to claim 31, wherein the distance "d3" is 76 µm (3 mils).

33. Method according to claim 1, further comprising a separate and distinct contact tip structure (168) mounted to the contact end portion (904) of each of the microelectronic spring contact elements.

34. Method according to claim 33, wherein the contact tip structure (168) has a different metallurgy than the microelectronic spring contact elements.

35. Method according to claim 1, further comprising:
cavities (442) formed in the surface of the electronic component (910) extending from underneath the contact end portion (904) of a corresponding one of the microelectronic spring contact elements towards the base end portion (902) of the microelectronic spring contact element, said cavities (442) allowing the contact ends portion (904) to deflect below the surface of the electronic component (910).

36. Method according to claim 1, further comprising a rigid material disposed on the surface of the electronic component (910), said rigid material extending from the base end portion (902) of a corresponding one of the microelectronic spring contact elements partially along the beam (900) towards the contact end portion (904) of the microelectronic spring contact element.

37. An electronic component comprising:
an electronic component (910) having a plurality of first terminals (912) on a surface thereof; and
a plurality of microelectronic spring contact elements, each comprising:
a base end portion (902),
an electrically conductive resilient cantilever beam (900), and
a contact end portion (904) opposite the base end portion (902), the contact end portion (904) of the beam (900) being elevated above the surface of the electronic component (910) to a position which is laterally offset from the respective base end portion (902);
wherein each of the microelectronic spring contact elements is mounted by its base end portion (902) to one of the first terminals (912),' wherein the contact end portion (904) is adapted in use to make a pressure connection with a second electronic component,
**characterized by**
the electronic component (910) further comprising at least one second terminal (914), wherein the at least one second terminal is electrically connected to ground;
and
each of the microelectronic spring contact elements further comprising:
an insulating layer (920) enveloping at least a portion of its base end (902) and beam (900); and
a conductive layer (922) enveloping at least a portion of the insulating layer (920) and the at least one second terminal (914).

38. Electronic component according to claim 37, wherein:
the beam (900) has a length "L";
the contact end portion (904) protrudes in the first direction from the beam (900) by a distance "d1"; and
the base end portion (902) protrudes in the second direction opposite the first direction from the beam by a distance "d2".

39. Electronic component according to claim 38, wherein the distance "d1" is in the range of 76- 381 µm (3-15 mils).

40. Electronic component according to claim 39, wherein the distance "d1" is approximately 178 µm (7 mils).

41. Electronic component according to claim 38, wherein the distance "d2" is in the range of 0 - 381 µm (0-15 mils).

42. Electronic component according to claim 41, wherein the distance "d2" is approximately 178 µm (7 mils).

43. Electronic component according to claim 38, wherein
the distance "d1" is in the range of 76 - 381 µm (3-15 mils); and
the distance "d2" is in the range of 0 - 381 µm (0-15 mils).

44. Electronic component according to claim 37, wherein the cantilever beam (900) is thicker at the base end portion (902) than at the contact end portion (904).

45. Electronic component according to claim 37, wherein a thickness "t1" of the base end portion (902) is in the range of 25.4 - 254 µm (1-10 mils).

46. Electronic component according to claim 45, wherein the thickness "t1" of the base end portion (902) is in the range of 51 - 127 µm (2-5 mils).

47. Electronic component according to claim 37, wherein a thickness "t2" of the contact end portion (904) is in the range of 25.4 - 254 µm (1-10 mils).

48. Electronic component according to claim 47, wherein the thickness "t2" of the contact end portion (904) is in the range of 25.4 - 127 µm (1-5 mils).

49. Electronic component according to claim 44, wherein the cantilever beam (900) has a thickness taper angle "β" in the range of 0-30 degrees.

50. Electronic component according to claim 49, wherein the cantilever beam (900) has a thickness taper angle "β" in the range of 0-6 degrees.

51. Electronic component according to claim 37, wherein the cantilever beam (900) is wider at the base end portion (902) than at the contact end portion (904).

52. Electronic component according to claim 37, wherein a width "w1" of the base end portion (902) is in the range of 76 - 508 µm (3-20 mils).

53. Electronic component according to claim 52, wherein the width "w1" of the base end portion (902) is in the range of 203 - 305 µm (8-12 mils).

54. Electronic component according to claim 37, wherein a width "w2" of the contact end portion (904) is in the range of 25.4 - 254 µm (1-10 mils).

55. Electronic component according to claim 54, wherein the width "w2" of the contact end portion (904) is in the range of 51 - 203 µm (2-8 mils).

56. Electronic component according to claim 51, wherein the cantilever beam (900) has a widthwise taper angle "α" in the range of 2-6 degrees.

57. Electronic component according to claim 37, wherein the cantilever beam (900) is thicker at the base end portion (902) than at the contact end portion (904);
the cantilever beam (900) is wider at the base end portion (902) than at the contact end portion (904);
the cantilever beam (900) has a thickness taper angle "β" in the range of 0-6 degrees; and
the cantilever beam (900) has a widthwise taper angle "α" in the range of 2-6 degrees.

58. Electronic component according to claim 38, wherein the length "L" is in the range of 254 µm - 25.4 mm (10-1000 mils).

59. Electronic component according to claim 58, wherein the length "L" is in the range of 1524 - 2540 µm (60-100 mils).

60. Electronic component according to claim 38, wherein
the cantilever beam (900) composes a microelectronic spring contact element that has an overall height "H" which is the sum of "d1", "d2" and a thickness of the beam (900); and
the overall height "H" is in the range of 102 - 1016 µm (4-40 mils).

61. Electronic component according to claim 60, wherein the overall height "H" is in the range of 127 - 305 µm (5-12 mils).

62. Electronic component according to claim 38, wherein
the cantilever beam (900) composes a microelectronic spring contact element that has an overall height "H" which is the sum of "d1", "d2" and a thickness of the beam (900); and
the length "L" is approximately at least FIVE times the overall height "H".

63. Electronic component according to claim 38, wherein
the cantilever beam (900) composes a microelectronic spring contact element that has an overall height "H" which is the sum of "d1 ", "d2" and a thickness of the beam (900); and
the distance "d1" is between one-fifth and one-half the size of the overall height "H".

64. Electronic component according to claim 38, wherein:
the cantilever beam (900) composes a microelectronic spring contact element that has an overall height "H" which is the sum of "d1", "d2" and a thickness of the beam (900);
the beam has a width "w1" at its base end portion (902);
the beam has a width "w2" at its contact end portion (904); and
the width "w2" is between one-tenth and one-half the size of the overall height "H".

65. Electronic component according to claim 37, wherein the contact end portion (904) is provided with an integral protruding feature (108, 158).

66. Electronic component according to claim 65, wherein the integral protruding feature (108, 158) is in the form of a pyramid or a truncated pyramid.

67. Electronic component according to claim 65, wherein the integral protruding feature (108, 158) protrudes a distance "d3" from a surface of the contact end portion (904) which is in the range of 6.3 - 127 µm (0.25 - 5 mils).

68. Electronic component according to claim 67, wherein the distance "d3" is 76 µm (3 mils).

69. Electronic component according to claim 37, further comprising a separate and distinct contact tip structure (168) mounted to the contact end portion (904) of the beam (900).

70. Electronic component according to claim 69, wherein the contact tip structure (168) has a different metallurgy than the cantilever beam (900).

71. Electronic component according to claim 37, wherein the predetermined voltage level is ground.

72. Electronic component according to any of claims 37 to 71, wherein the conductive layer (922) is a continuous conductive layer.

## Patentansprüche

1. Verfahren zum Anbringen mikroelektronischer Federkontaktelemente an einer elektronischen Komponente (910),
wobei die elektronische Komponente (910) aufweist:
eine Vielzahl von ersten Anschlüssen (912) auf einer ihrer Flächen; wobei die elektronische Komponente (910) weiterhin zumindest einen zweiten Anschluss (914) aufweist; und
wobei jedes mikroelektronische Federkontaktelement aufweist:
einen elektrisch leitenden, elastischen Ausleger (900), der aufweist: einen Kontakt-Endabschnitt (904), der vom Ausleger (900) aus in eine erste Richtung hervorspringt, und einen Basis-Endabschnitt (902), der vom Ausleger (900) aus in eine zweite Richtung hervorspringt; wobei der Kontakt-Endabschnitt (904) des Auslegers (900) über die Fläche der elektronischen Komponente (9101) bis zu einer Position erhöht ist, die seitlich versetzt zum Basis-Endabschnitt (902) liegt, und das Verfahren die Schritte aufweist:
für jedes mikroelektronische Federkontaktelement, Anbringen des Basis-Endabschnitts (902) an einen der ersten Anschlüsse (912) der elektronischen Komponente (910),
Maskieren der Kontakt-Endabschnitte (904),
Aufbringen einer isolierenden Schicht (920), die zumindest einen Teil der Ausleger (900) umhüllt; und
Aufbringen einer leitenden Schicht (922), die zumindest einen Teil der isolierenden Schicht (920) umhüllt.

2. Verfahren nach Anspruch 1, wobei:
der Ausleger (900) eine Länge "L" aufweist;
der Kontakt-Endabschnitt (904) vom Ausleger (900) aus in die erste Richtung um die Strecke "d1" hervorspringt; und
der Basis-Endabschnitt (902) vom Ausleger (900) aus in die zweite Richtung entgegengesetzt zur ersten Richtung um die Strecke "d2" hervorspringt;
wobei der Kontakt-Endabschnitt (904) so angepasst ist, dass er bei Verwendung eine Druckverbindung mit einer zweiten elektronischen Komponente herstellt.

3. Verfahren nach Anspruch 2, wobei die Strecke "d1" im Bereich von 76 - 381 µm (3-15 mils) liegt.

4. Verfahren nach Anspruch 3, wobei die Strecke "d1" etwa 178 µm (7 mils) beträgt.

5. Verfahren nach Anspruch 2, wobei die Strecke "d2" im Bereich von 0 - 381 µm (0-15 mils) liegt.

6. Verfahren nach Anspruch 5, wobei die Strecke "d2" etwa 178 µm (7 mils) beträgt.

7. Verfahren nach Anspruch 2, wobei
die Strecke "d1" im Bereich von 76 - 381 µm (3-15 mils) liegt; und
die Strecke "d2" im Bereich von 0 - 381 µm (0-15 mils) liegt.

8. Verfahren nach Anspruch 1, wobei jede der mikroelektronischen Federkontaktelemente am Basis-Endabschnitt (902) dicker als am Kontakt-Endabschnitt (904) ist.

9. Verfahren nach Anspruch 1, wobei eine Dicke "t1" des Basis-Endabschnitts (902) im Bereich von 25,4 - 254 µm (1-10 mils) liegt

10. Verfahren nach Anspruch 9, wobei die Dicke "t1" des Basis-Endabschnitts (902) im Bereich von 51 - 127 µm (2-5 mils) liegt

11. Verfahren nach Anspruch 1, wobei eine Dicke "t2" des Kontakt-Endabschnitts (904) im Bereich von 25,4 - 254 µm (1-10 mils) liegt.

12. Verfahren nach Anspruch 11, wobei die Dicke "t2" des Kontakt-Endabschnitts (904) im Bereich von 25,4 - 127 µm (1-5 mils) liegt.

13. Verfahren nach Anspruch 8, wobei jedes der mikroelektronischen Federkontaktelemente in der Dicke einen Verjüngungswinkel "β" im Bereich von 0-30 Grad aufweist.

14. Verfahren nach Anspruch 13, wobei jedes der mikroelektronischen Federkontaktelemente in der Dicke einen Verjüngungswinkel "β" im Bereich von 0-6 Grad aufweist.

15. Verfahren nach Anspruch 1, wobei jedes der mikroelektronischen Federkontaktelemente am Basis-Endabschnitt (902) breiter als am Kontakt-Endabschnitt (904) ist.

16. Verfahren nach Anspruch 1, wobei eine Breite "w1" des Basis-Endabschnitts (902) im Bereich von 76 - 508 µm (3-20 mils) liegt.

17. Verfahren nach Anspruch 16, wobei die Breite "w1" des Basis-Endabschnitts (902) im Bereich von 203 - 305 µm (8-12 mils) liegt.

18. Verfahren nach Anspruch 1, wobei eine Breite "w2" des Kontakt-Endabschnitts (904) im Bereich von 25,4 - 254 µm (1-10 mils) liegt.

19. Verfahren nach Anspruch 18, wobei die Breite "w2" des Kontakt-Endabschnitts (904) im Bereich von 51 - 203 µm (2-8 mils) liegt.

20. Verfahren nach Anspruch 15, wobei jedes der mikroelektronischen Federkontaktelemente in der Breite einen Verjüngungswinkel "α" im Bereich von 2-6 Grad aufweist.

21. Verfahren nach Anspruch 1, wobei jedes der mikroelektronischen Federkontaktelemente am Basis-Endabschnitt (902) dicker als am Kontakt-Endabschnitt (904) ist;
jedes der mikroelektronischen Federkontaktelemente am Basis-Endabschnitt (902) breiter als am Kontakt-Endabschnitt (904) ist;
jedes der mikroelektronischen Federkontaktelemente in der Dicke einen Verjüngungswinkel "β" im Bereich von 0-6 Grad aufweist; und
jedes der mikroelektronischen Federkontaktelemente in der Breite einen Verjüngungswinkel "α" im Bereich von 2-6 Grad aufweist.

22. Verfahren nach Anspruch 2, wobei die Länge "L" im Bereich von 254 µm - 25,4 mm (10-1000 mils) liegt.

23. Verfahren nach Anspruch 22, wobei die Länge "L" im Bereich von 1524 - 2540 µm (60-100 mils) liegt.

24. Verfahren nach Anspruch 2, wobei
jedes der mikroelektronischen Federkontaktelemente eine Gesamthöhe "H" aufweist, die die Summe von "d1", "d2" und einer Dicke des Auslegers (900) ist; und
die Gesamthöhe "H" im Bereich von 102 - 1016 µm (4-40 mils) liegt.

25. Verfahren nach Anspruch 24, wobei die Gesamthöhe "H" im Bereich von 127 - 305 µm (5-12 mils) liegt.

26. Verfahren nach Anspruch 2, wobei
jedes der mikroelektronischen Federkontaktelemente eine Gesamthöhe "H" aufweist, die die Summe von "d1", "d2" und einer Dicke des Auslegers (900) ist; und
die Länge "L" annähernd zumindest FÜNF-mal der Gesamthöhe "H" entspricht.

27. Verfahren nach Anspruch 2, wobei
jedes der mikroelektronischen Federkontaktelemente eine Gesamthöhe "H" aufweist, die die Summe von "d1", "d2" und einer Dicke des Auslegers (900) ist; und
die Strecke "d1" zwischen einem Fünftel und der Hälfte der Größe der Gesamthöhe "H" liegt.

28. Verfahren nach Anspruch 2, wobei
jedes der mikroelektronischen Federkontaktelemente eine Gesamthöhe "H" aufweist, die die Summe von "d1", "d2" und einer Dicke des Auslegers (900) ist; und
der Ausleger eine Breite "w1" an seinem Basis-Endabschnitt (902) aufweist;
der Ausleger eine Breite "w2" an seinem Kontakt-Endabschnitt (904) aufweist; und
die Breite "w2" zwischen einem Zehntel und der Hälfte der Größe der Gesamthöhe "H" liegt.

29. Verfahren nach Anspruch 1, wobei der Kontakt-Endabschnitt (904) mit einem integrierten, hervorspringenden Merkmal (108, 158) versehen ist.

30. Verfahren nach Anspruch 29, wobei das integrierte, hervorspringende Merkmal (108, 158) die Form einer Pyramide oder eines Pyramidenstumpfes aufweist.

31. Verfahren nach Anspruch 29, wobei das integrierte, hervorspringende Merkmal (108, 158) von einer Fläche des Kontakt-Endabschnitts (904) um eine Strecke "d3", welche im Bereich von 6,3 - 127 µm (0,25 - 5 mils) liegt, hervorspringt.

32. Verfahren nach Anspruch 31, wobei die Strecke "d3" 76 µm (3 mils) beträgt.

33. Verfahren nach Anspruch 1, das weiterhin eine separat ausgeprägte Kontaktspitzenstruktur (168) aufweist, die an den Kontakt-Endabschnitt (904) von jedem der mikroelektronischen Federkontaktelemente befestigt ist.

34. Verfahren nach Anspruch 33, wobei die Kontaktspitzenstruktur (168) eine von den mikroelektronischen Federkontaktelementen unterschiedliche Metallurgie aufweist.

35. Verfahren nach Anspruch 1, das weiterhin aufweist:
Vertiefungen (442), die in der Fläche der elektronischen Komponente (910) ausgebildet sind und sich von unterhalb des Kontakt-Endabschnitts (904) eines entsprechenden der mikroelektronischen Federkontaktelemente zum Basis-Endabschnitt (902) des mikroelektronischen Federkontaktelements erstrecken, wobei es die Vertiefungen (442) den Kontakt-Endabschnitten (904) ermöglichen, dass diese unter die Oberfläche der elektronischen Komponente (910) ausgelenkt werden.

36. Verfahren nach Anspruch 1, das weiterhin ein auf der Fläche der elektronischen Komponente (910) angeordnetes, steifes Material aufweist, wobei sich das steife Material vom Basis-Endabschnitt (902) eines entsprechenden der mikroelektronischen Federkontaktelemente teilweise entlang des Auslegers (900) zum Kontakt-Endabschnitt (904) des mikroelektronischen Federkontaktelements erstreckt.

37. Elektronische Komponente, die aufweist:
eine elektronische Komponente (910) mit einer Vielzahl von ersten Anschlüssen (912) auf einer ihrer Flächen; und
eine Vielzahl von mikroelektronischen Federkontaktelementen, von denen jedes aufweist:
einen Basis-Endabschnitt (902),
einen elektrisch leitenden, elastischen, freitragenden Ausleger (900), und
einen Kontakt-Endabschnitt (904) gegenüberliegend zum Basis-Endabschnitt (902), wobei der Kontakt-Endabschnitt (904) des Auslegers (900) über die Fläche der elektronischen Komponente (910) in eine Position erhöht ist, die seitlich versetzt zum entsprechenden Basis-Endabschnitt (902) ist;
wobei jedes der mikroelektronischen Federkontaktelemente an seinem Basis-Endbereich (902) an einem der ersten Anschlüsse (912) angebracht ist, wobei der Kontakt-Endbereich (904) so angepasst ist, dass er bei Verwendung eine Druckverbindung mit einer zweiten elektronischen Komponente ausbildet,
**dadurch gekennzeichnet, dass**
die elektronische Komponente (910) weiterhin zumindest einen zweiten Anschluss (914) aufweist, wobei der zumindest eine zweite Anschluss elektrisch mit Masse verbunden ist; und
jedes der mikroelektronischen Federkontaktelemente weiterhin aufweist:
eine isolierende Schicht (920), die zumindest einen Teil seines Basis-Endes (902) und Auslegers (900) umhüllt; und
eine leitende Schicht (922), die zumindest einen Teil der isolierenden Schicht (920) und den zumindest einen zweiten Anschluss (914) umhüllt.

38. Elektronische Komponente nach Anspruch 37, wobei:
der Ausleger (900) eine Länge "L" aufweist;
der Kontakt-Endabschnitt (904) vom Ausleger (900) aus in die erste Richtung um die Strecke "d1" hervorspringt; und
der Basis-Endabschnitt (902) vom Ausleger (900) aus in die zweite Richtung, entgegengesetzt zur ersten Richtung, um die Strecke "d2" hervorspringt.

39. Elektronische Komponente nach Anspruch 38, wobei die Strecke "d1" im Bereich von 76 - 381 µm (3-15 mils) liegt.

40. Elektronische Komponente nach Anspruch 39, wobei die Strecke "d1" etwa 178 µm (7 mils) beträgt.

41. Elektronische Komponente nach Anspruch 38, wobei die Strecke "d2" im Bereich von 0 - 381 µm (0-15 mils) liegt.

42. Elektronische Komponente nach Anspruch 41, wobei die Strecke "d2" etwa 178 µm (7 mils) beträgt.

43. Elektronische Komponente nach Anspruch 38, wobei
die Strecke "d1" im Bereich von 76 - 381 µm (3-15 mils) liegt; und
die Strecke "d2" im Bereich von 0 - 381 µm (0-15 mils) liegt.

44. Elektronische Komponente nach Anspruch 37, wobei der freitragende Ausleger (900) am Basis-Endabschnitt (902) dicker als am Kontakt-Endabschnitt (904) ist.

45. Elektronische Komponente nach Anspruch 37, wobei eine Dicke "t1" des Basis-Endabschnitts (902) im Bereich von 25,4 - 254 µm (1-10 mils) liegt.

46. Elektronische Komponente nach Anspruch 45, wobei die Dicke "t1" des Basis-Endabschnitts (902) im Bereich von 51 - 127 µm (2-5 mils) liegt.

47. Elektronische Komponente nach Anspruch 37, wobei eine Dicke "t2" des Kontakt-Endabschnitts (904) im Bereich von 25,4 - 254 µm (1-10 mils) liegt.

48. Elektronische Komponente nach Anspruch 47, wobei die Dicke "t2" des Kontakt-Endabschnitts (904) im Bereich von 25,4 - 127 µm (1-5 mils) liegt.

49. Elektronische Komponente nach Anspruch 44, wobei der freitragende Ausleger (900) in der Dicke einen Verjüngungswinkel "β" im Bereich von 0-30 Grad aufweist.

50. Elektronische Komponente nach Anspruch 49, wobei der freitragende Ausleger (900) in der Dicke einen Verjüngungswinkel "β" im Bereich von 0-6 Grad aufweist.

51. Elektronische Komponente nach Anspruch 37, wobei der freitragende Ausleger (900) am Basis-Endabschnitt (902) breiter als am Kontakt-Endabschnitt (904) ist.

52. Elektronische Komponente nach Anspruch 37, wobei eine Breite "w1" des Basis-Endabschnitts (902) im Bereich von 76 - 508 µm (3-20 mils) liegt.

53. Elektronische Komponente nach Anspruch 52, wobei die Breite "w1" des Basis-Endabschnitts (902) im Bereich von 203 - 305 µm (8-12 mils) liegt.

54. Elektronische Komponente nach Anspruch 37, wobei eine Breite "w2" des Kontakt-Endabschnitts (904) im Bereich von 25,4 - 254 µm (1-10 mils) liegt.

55. Elektronische Komponente nach Anspruch 54, wobei die Breite "w2" des Kontakt-Endabschnitts (904) im Bereich von 51 - 203 µm (2-8 mils) liegt.

56. Elektronische Komponente nach Anspruch 51, wobei der freitragende Ausleger (900) in der Breite einen Verjüngungswinkel "α" im Bereich von 2-6 Grad aufweist.

57. Elektronische Komponente nach Anspruch 37, wobei der freitragende Ausleger (900) am Basis-Endabschnitt (902) dicker als am Kontakt-Endabschnitt (904) ist;
der freitragende Ausleger (900) am Basis-Endabschnitt (902) breiter als am Kontakt-Endabschnitt (904) ist;
der freitragende Ausleger (900) in der Dicke einen Verjüngungswinkel "β" im Bereich von 0-6 Grad aufweist; und
der freitragende Ausleger (900) in der Breite einen Verjüngungswinkel "α" im Bereich von 2-6 Grad aufweist.

58. Elektronische Komponente nach Anspruch 38, wobei die Länge "L" im Bereich von 254 µm - 25,4 mm (10-1000 mils) liegt.

59. Elektronische Komponente nach Anspruch 58, wobei die Länge "L" im Bereich von 1524 - 2540 µm (60-100 mils) liegt.

60. Elektronische Komponente nach Anspruch 38, wobei
der freitragende Ausleger (900) ein mikroelektronisches Federkontaktelement ausbildet, das eine Gesamthöhe "H" aufweist, welche die Summe von "d1", "d2" und einer Dicke des Auslegers (900) ist; und
die Gesamthöhe "H" im Bereich von 102 - 1016µm (4-40 mils) liegt.

61. Elektronische Komponente nach Anspruch 60, wobei die Gesamthöhe "H" im Bereich von 127 - 305 µm (5-12 mils) liegt.

62. Elektronische Komponente nach Anspruch 38, wobei
der freitragende Ausleger (900) ein mikroelektronisches Federkontaktelement ausbildet, das eine Gesamthöhe "H" aufweist, welche die Summe von "d1", "d2" und einer Dicke des Auslegers (900) ist; und
die Länge "L" annähernd zumindest FÜNF-mal der Gesamthöhe "H" entspricht.

63. Elektronische Komponente nach Anspruch 38, wobei
der freitragende Ausleger (900) ein mikroelektronisches Federkontaktelement ausbildet, das eine Gesamthöhe "H" aufweist, welche die Summe von "d1", "d2" und einer Dicke des Auslegers (900) ist; und
die Strecke "d1" zwischen einem Fünftel und der Hälfte der Größe der Gesamthöhe "H" liegt.

64. Elektronische Komponente nach Anspruch 38, wobei:
der freitragende Ausleger (900) ein mikroelektronisches Federkontaktelement ausbildet, das eine Gesamthöhe "H" aufweist, welche die Summe von "d1", "d2" und einer Dicke des Auslegers (900) ist; und
der Ausleger eine Breite "w1" an seinem Basis-Endbereich (902) aufweist;
der Ausleger eine Breite "w2" an seinem Kontakt-Endbereich (902) aufweist; und
die Breite "w2" zwischen einem Zehntel und der Hälfte der Größe der Gesamthöhe "H" liegt.

65. Elektronische Komponente nach Anspruch 37, wobei der Kontakt-Endabschnitt (904) mit einem integrierten, hervorspringenden Merkmal (108, 158) versehen ist.

66. Elektronische Komponente nach Anspruch 65, wobei das integrierte, hervorspringende Merkmal (108, 158) die Form einer Pyramide oder eines Pyramidenstumpfes aufweist.

67. Elektronische Komponente nach Anspruch 65, wobei das integrierte, hervorspringende Merkmal (108, 158) von einer Fläche des Kontakt-Endabschnitts (904) um eine Strecke "d3" hervorspringt, welche im Bereich von 6,3 - 127 µm (0,25 - 5 mils) liegt.

68. Elektronische Komponente nach Anspruch 67, wobei die Strecke "d3" 76 µm (3 mils) beträgt.

69. Elektronische Komponente nach Anspruch 37, welche weiterhin eine separat ausgeprägte Kontaktspitzenstruktur (168) aufweist, die am Kontakt-Endabschnitt (904) des Auslegers befestigt ist.

70. Elektronische Komponente nach Anspruch 69, wobei die Kontaktspitzenstruktur (168) eine vom freitragenden Ausleger (900) unterschiedliche Metallurgie aufweist.

71. Elektronische Komponente nach Anspruch 37, wobei die vorbestimmte Spannung Masse ist.

72. Elektronische Komponente nach einem der Ansprüche 37 bis 71, wobei die leitende Schicht (922) eine zusammenhängende, leitende Schicht ist.

## Revendications

1. Procédé de montage d'éléments de contact à ressort micro-électronique sur un composant électronique (910),
le composant électronique (910) comprenant :
une pluralité de premières bornes (912) sur une surface de celui-ci ;
le composant électronique (910) comprenant en outre au moins une deuxième borne (914) ; et
chaque élément de contact à ressort micro-électronique comprenant :
une poutre élastique conductrice électriquement (900) comprenant une portion d'extrémité de contact (904) faisant saillie de la poutre (900) dans une première direction et une portion d'extrémité de base (902) faisant saillie de la poutre (900) dans une deuxième direction ; la portion d'extrémité de contact (904) de la poutre (900) étant élevée au-dessus de la surface du composant électronique (910) à une position qui est latéralement décalée par rapport à la portion d'extrémité de base (902), et
le procédé comprenant les étapes consistant à :
pour chaque élément de contact à ressort micro-électronique, attacher la portion d'extrémité de base (902) à l'une des premières bornes (912) du composant électronique (910),
masquer les portions d'extrémité de contact (904),
déposer une couche isolante (920) enveloppant au moins une portion de la poutre (900) ; et
déposer une couche conductrice (922) enveloppant au moins une portion de la couche isolante (920).

2. Procédé selon la revendication 1, dans lequel :
la poutre (900) a une longueur « L » ;
la portion d'extrémité de contact (904) fait saillie dans la première direction de la poutre (900) d'une distance « d1 » ; et
la portion d'extrémité de base (902) fait saillie dans la deuxième direction opposée à la première direction de la poutre d'une distance « d2 » ;
dans lequel la portion d'extrémité de contact (904) est apte en utilisation à établir une connexion de pression avec un deuxième composant électronique.

3. Procédé selon la revendication 2, dans lequel la distance « d1 » est dans la plage de 76 à 381 µm (3 à 15 mils).

4. Procédé selon la revendication 3, dans lequel la distance « d1 » est approximativement 178 µm (7 mils).

5. Procédé selon la revendication 2, dans lequel la distance « d2 » est dans la plage de 0 à 381 µm (0 à 15 mils).

6. Procédé selon la revendication 5, dans lequel la distance « d2 » est approximativement 178 µm (7 mils).

7. Procédé selon la revendication 2, dans lequel
la distance « d1 » est dans la plage de 76 à 381 µm (3 à 15 mils) ; et
la distance « d2 » est dans la plage de 0 à 381 µm (0 à 15 mils).

8. Procédé selon la revendication 1, dans lequel chaque élément de contact à ressort micro-électronique est plus épais au niveau de la portion d'extrémité de base (902) qu'au niveau de la portion d'extrémité de contact (904).

9. Procédé selon la revendication 1, dans lequel une épaisseur « t1 » de la portion d'extrémité de base (902) est dans la plage de 25,4 à 254 µm (1 à 10 mils).

10. Procédé selon la revendication 9, dans lequel l'épaisseur « t1 » de la portion d'extrémité de base (902) est dans la plage de 51 à 127 µm (2 à 5 mils).

11. Procédé selon la revendication 1, dans lequel une épaisseur « t2 » de la portion d'extrémité de contact (904) est dans la plage de 25,4 à 254 µm (1 à 10 mils).

12. Procédé selon la revendication 11, dans lequel l'épaisseur « t2 » de la portion d'extrémité de contact (904) est dans la plage de 25,4 à 127 µm (1 à 5 mils).

13. Procédé selon la revendication 8, dans lequel chacun des éléments de contact à ressort micro-électronique a un angle de cône ou de réduction d'épaisseur « β » dans la plage de 0 à 30 degrés.

14. Procédé selon la revendication 13, dans lequel chacun des éléments de contact à ressort micro-électronique a un angle de cône ou de réduction d'épaisseur « β » dans la plage de 0 à 6 degrés.

15. Procédé selon la revendication 1, dans lequel chacun des éléments de contact à ressort micro-électronique est plus large au niveau de la portion d'extrémité de base (902) qu'au niveau de la portion d'extrémité de contact (904).

16. Procédé selon la revendication 1, dans lequel une largeur « w1 » de la portion d'extrémité de base (902) est dans la plage de 76 à 508 µm (3 à 20 mils).

17. Procédé selon la revendication 16, dans lequel la largeur « w1 » de la portion d'extrémité de base (902) est dans la plage de 203 à 305 µm (8 à 12 mils).

18. Procédé selon la revendication 1, dans lequel une largeur « w2 » de la portion d'extrémité de contact (904) est dans la plage de 25,4 à 254 µm (1 à 10 mils).

19. Procédé selon la revendication 18, dans lequel la largeur « w2 » de la portion d'extrémité de contact (904) est dans la plage de 51 à 203 µm (2 à 8 mils).

20. Procédé selon la revendication 15, dans lequel chacun des éléments de contact à ressort micro-électronique a un angle de cône ou de réduction de largeur « α » dans la plage de 2 à 6 degrés.

21. Procédé selon la revendication 1, dans lequel chacun des éléments de contact à ressort micro-électronique est plus épais au niveau de la portion d'extrémité de base (902) qu'au niveau de la portion d'extrémité de contact (904) ;
chacun des éléments de contact à ressort micro-électronique est plus large au niveau de la portion d'extrémité de base (902) qu'au niveau de la portion d'extrémité de contact (904) ;
chacun des éléments de contact à ressort micro-électronique a un angle de cône ou de réduction d'épaisseur « β » dans la plage de 0 à 6 degrés ; et
chacun des éléments de contact à ressort micro-électronique a un angle de cône ou de réduction de largeur « α » dans la plage de 2 à 6 degrés.

22. Procédé selon la revendication 2, dans lequel la longueur « L » est dans la plage de 254 µm à 25,4 mm (10 à 1 000 mils).

23. Procédé selon la revendication 22, dans lequel la longueur « L » est dans la plage de 1 524 µm à 2 540 µm (60 à 100 mils).

24. Procédé selon la revendication 2, dans lequel
chacun des éléments de contact à ressort micro-électronique a une hauteur hors tout « H » qui est la somme de « d1 », « d2 » et d'une épaisseur de la poutre (900) ; et
la hauteur hors tout « H » est dans la plage de 102 à 1 016 µm (4 à 40 mils).

25. Procédé selon la revendication 24, dans lequel la hauteur hors tout « H » est dans la plage de 127 à 305 µm (5 à 12 mils).

26. Procédé selon la revendication 2, dans lequel
chacun des éléments de contact à ressort micro-électronique a une hauteur hors tout « H » qui est la somme de « d1 », « d2 » et d'une épaisseur de la poutre (900) ; et
la longueur « L » est égale à approximativement au moins CINQ fois la hauteur hors tout « H ».

27. Procédé selon la revendication 2, dans lequel
chacun des éléments de contact à ressort micro-électronique a une hauteur hors tout « H » qui est la somme de « d1 », « d2 » et d'une épaisseur de la poutre (900) ; et
la distance « d1 » est entre un cinquième et une moitié de la taille de la hauteur hors tout « H ».

28. Procédé selon la revendication 2, dans lequel
chacun des éléments de contact à ressort micro-électronique a une hauteur hors tout « H » qui est la somme de « d1 », « d2 » et d'une épaisseur de la poutre (900) ;
la poutre a une largeur « w1 » à sa portion d'extrémité de base (902) ;
la poutre a une largeur « w2 » à sa portion d'extrémité de contact (904) ; et
la largeur « w2 » est entre un dixième et une moitié de la taille de la hauteur hors tout « H ».

29. Procédé selon la revendication 1, dans lequel la portion d'extrémité de contact (904) est munie d'une caractéristique protubérante intégrale (108, 158).

30. Procédé selon la revendication 29, dans lequel la caractéristique protubérante intégrale (108, 158) a la forme d'une pyramide ou d'une pyramide tronquée.

31. Procédé selon la revendication 29, dans lequel la caractéristique protubérante intégrale (108, 158) fait saillie d'une distance « d3 » à partir d'une surface de la portion d'extrémité de contact (904) qui est dans la plage de 6,3 à 127 µm (0,25 à 5 mils).

32. Procédé selon la revendication 31, dans lequel la distance « d3 » est de 76 µm (3 mils).

33. Procédé selon la revendication 1, comprenant en outre une structure d'embout de contact séparée et distincte (168) montée sur la portion d'extrémité de contact (904) de chacun des éléments de contact à ressort micro-électronique.

34. Procédé selon la revendication 33, dans lequel la structure d'embout de contact (168) a une métallurgie différente de celle des éléments de contact à ressort micro-électronique.

35. Procédé selon la revendication 1, comprenant en outre :
des cavités (442) formées dans la surface du composant électronique (910) s'étendant de dessous la portion d'extrémité de contact (904) de l'un correspondant des éléments de contact à ressort micro-électronique vers la portion d'extrémité de base (902) de l'élément de contact à ressort micro-électronique, lesdites cavités (442) permettant à la portion d'extrémité de contact (904) d'être déviée au-dessous de la surface du composant électronique (910).

36. Procédé selon la revendication 1, comprenant en outre un matériau rigide disposé sur la surface du composant électronique (910), ledit matériau rigide s'étendant de la portion d'extrémité de base (902) de l'un correspondant des éléments de contact à ressort micro-électronique partiellement le long de la poutre (900) vers la portion d'extrémité de contact (904) de l'élément de contact à ressort micro-électronique.

37. Composant électronique comprenant :
un composant électronique (910) ayant une pluralité de premières bornes (912) sur une surface de celui-ci ; et
une pluralité d'éléments de contact à ressort micro-électronique, comprenant chacun :
une portion d'extrémité de base (902),
une poutre en porte-à-faux élastique conductrice électriquement (900), et
une portion d'extrémité de contact (904) opposée à la portion d'extrémité de base (902), la portion d'extrémité de contact (904) de la poutre (900) étant élevée au-dessus de la surface du composant électronique (910) à une position qui est latéralement décalée par rapport à la portion d'extrémité de base (902) ;
dans lequel chacun des éléments de contact à ressort micro-électronique est monté par sa portion d'extrémité de base (902) sur l'une des premières bornes (912), dans lequel la portion d'extrémité de contact (904) est apte en utilisation à établir une connexion de pression avec un deuxième composant électronique,
**caractérisé par**
le composant électronique (910) comprenant en outre au moins une deuxième borne (914), dans lequel ladite au moins une deuxième borne est électriquement connectée à la masse ; et
chacun des éléments de contact à ressort micro-électronique comprenant en outre :
une couche isolante (920) enveloppant au moins une portion de son extrémité de base (902) et la poutre (900) ; et
une couche conductrice (922) enveloppant au moins une portion de la couche isolante (920) et ladite au moins une deuxième borne (914).

38. Composant électronique selon la revendication 37, dans lequel :
la poutre (900) a une longueur « L » ;
la portion d'extrémité de contact (904) fait saillie dans la première direction à partir de la poutre (900) d'une distance « d1 » ; et
la portion d'extrémité de base (902) fait saillie dans la deuxième direction opposée à la première direction de la poutre d'une distance « d2 ».

39. Composant électronique selon la revendication 38, dans lequel la distance « d1 » est dans la plage de 76 à 381 µm (3 à 15 mils).

40. Composant électronique selon la revendication 39, dans lequel la distance « d1 » est approximativement 178 µm (7 mils).

41. Composant électronique selon la revendication 38, dans lequel la distance « d2 » est dans la plage de 0 à 381 µm (0 à 15 mils).

42. Composant électronique selon la revendication 41, dans lequel la distance « d2 » est approximativement 178 µm (7 mils).

43. Composant électronique selon la revendication 38, dans lequel
la distance « d1 » est dans la plage de 76 à 381 µm (3 à 15 mils) ; et
la distance « d2 » est dans la plage de 0 à 381 µm (0 à 15 mils).

44. Composant électronique selon la revendication 37, dans lequel la poutre en porte-à-faux (900) est plus épaisse au niveau de la portion d'extrémité de base (902) qu'au niveau de la portion d'extrémité de contact (904).

45. Composant électronique selon la revendication 37, dans lequel une épaisseur « t1 » de la portion d'extrémité de base (902) est dans la plage de 25,4 à 254 µm (1 à 10 mils).

46. Composant électronique selon la revendication 45, dans lequel l'épaisseur « t1 » de la portion d'extrémité de base (902) est dans la plage de 51 à 127 µm (2 à 5 mils).

47. Composant électronique selon la revendication 37, dans lequel une épaisseur « t2 » de la portion d'extrémité de contact (904) est dans la plage de 25,4 à 254 µm (1 à 10 mils).

48. Composant électronique selon la revendication 47, dans lequel l'épaisseur « t2 » de la portion d'extrémité de contact (904) est dans la plage de 25,4 à 127 µm (1 à 5 mils).

49. Composant électronique selon la revendication 44, dans lequel la poutre en porte-à-faux (900) a un angle de cône ou de réduction d'épaisseur « β » dans la plage de 0 à 30 degrés.

50. Composant électronique selon la revendication 49, dans lequel la poutre en porte-à-faux (900) a un angle de cône ou de réduction d'épaisseur « β » dans la plage de 0 à 6 degrés.

51. Composant électronique selon la revendication 37, dans lequel la poutre en porte-à-faux (900) est plus large au niveau de la portion d'extrémité de base (902) qu'au niveau de la portion d'extrémité de contact (904).

52. Composant électronique selon la revendication 37, dans lequel une largeur « w1 » de la portion d'extrémité de base (902) est dans la plage de 76 à 508 µm (3 à 20 mils).

53. Composant électronique selon la revendication 52, dans lequel la largeur « w1 » de la portion d'extrémité de base (902) est dans la plage de 203 à 305 µm (8 à 12 mils).

54. Composant électronique selon la revendication 37, dans lequel une largeur « w2 » de la portion d'extrémité de contact (904) est dans la plage de 25,4 à 254 µm (1 à 10 mils).

55. Composant électronique selon la revendication 54, dans lequel la largeur « w2 » de la portion d'extrémité de contact (904) est dans la plage de 51 à 203 µm (2 à 8 mils).

56. Composant électronique selon la revendication 51, dans lequel la poutre en porte-à-faux (900) a un angle de cône ou de réduction de largeur « α » dans la plage de 2 à 6 degrés.

57. Composant électronique selon la revendication 37, dans lequel la poutre en porte-à-faux (900) est plus épaisse au niveau de la portion d'extrémité de base (902) qu'au niveau de la portion d'extrémité de contact (904) ;
la poutre en porte-à-faux (900) est plus large au niveau de la portion d'extrémité de base (902) qu'au niveau de la portion d'extrémité de contact (904) ;
la poutre en porte-à-faux (900) a un angle de cône ou de réduction d'épaisseur « β » dans la plage de 0 à 6 degrés ; et
la poutre en porte-à-faux (900) a un angle de cône ou de réduction de largeur « α » dans la plage de 2 à 6 degrés.

58. Composant électronique selon la revendication 38, dans lequel la longueur « L » est dans la plage de 254 µm à 25,4 mm (10 à 1 000 mils).

59. Composant électronique selon la revendication 58, dans lequel la longueur « L » est dans la plage de 1524 µm à 2540 µm (60 à 100 mils).

60. Composant électronique selon la revendication 38, dans lequel
la poutre en porte-à-faux (900) compose un élément de contact à ressort micro-électronique qui a une hauteur hors tout « H » qui est la somme de « d1 », « d2 » et d'une épaisseur de la poutre (900) ; et
la hauteur hors tout « H » est dans la plage de 102 à 1 016 µm (4 à 40 mils).

61. Composant électronique selon la revendication 60, dans lequel la hauteur hors tout « H » est dans la plage de 127 à 305 µm (5 à 12 mils).

62. Composant électronique selon la revendication 38, dans lequel
la poutre en porte-à-faux (900) compose un élément de contact à ressort micro-électronique qui a une hauteur hors tout « H » qui est la somme de « d1 », « d2 » et d'une épaisseur de la poutre (900) ; et
la longueur « L » est égale à approximativement au moins CINQ fois la hauteur hors tout « H ».

63. Composant électronique selon la revendication 38, dans lequel
la poutre en porte-à-faux (900) compose un élément de contact à ressort micro-électronique qui a une hauteur hors tout « H » qui est la somme de « d1 », « d2 » et d'une épaisseur de la poutre (900) ; et
la distance « d1 » est entre un cinquième et une moitié de la taille de la hauteur hors tout « H ».

64. Composant électronique selon la revendication 38, dans lequel
la poutre en porte-à-faux (900) compose un élément de contact à ressort micro-électronique qui a une hauteur hors tout « H » qui est la somme de « d1 », « d2 » et d'une épaisseur de la poutre (900) ;
la poutre a une largeur « w1 » à sa portion d'extrémité de base (902) ;
la poutre a une largeur « w2 » à sa portion d'extrémité de contact (904) ; et
la largeur « w2 » est entre un dixième et une moitié de la taille de la hauteur hors tout « H ».

65. Composant électronique selon la revendication 37, dans lequel la portion d'extrémité de contact (904) est munie d'une caractéristique protubérante intégrale (108, 158).

66. Composant électronique selon la revendication 65, dans lequel la caractéristique protubérante intégrale (108, 158) a la forme d'une pyramide ou d'une pyramide tronquée.

67. Composant électronique selon la revendication 65, dans lequel la caractéristique protubérante intégrale (108, 158) fait saillie d'une distance « d3 » à partir d'une surface de la portion d'extrémité de contact (904) qui est dans la plage de 6,3 à 127 µm (0,25 à 5 mils).

68. Composant électronique selon la revendication 67, dans lequel la distance « d3 » est de 76 µm (3 mils).

69. Composant électronique selon la revendication 37, comprenant en outre une structure d'embout de contact séparée et distincte (168) montée sur la portion d'extrémité de contact (904) de la poutre (900).

70. Composant électronique selon la revendication 69, dans lequel la structure d'embout de contact (168) a une métallurgie différente de celle de la poutre (900).

71. Composant électronique selon la revendication 37, dans lequel le niveau de tension ou de voltage prédéterminé est une masse.

72. Composant électronique selon l'une quelconque des revendications 37 à 71, dans lequel la couche conductrice (922) est une couche conductrice continue.
